# EUROPÄISCHE PATENTSCHRIFT

(11) **EP 3 657 194 B1**
(45) Veröffentlichungstag und Bekanntmachung des Hinweises auf die Patenterteilung: **28.07.2021**
(21) Anmeldenummer: 19209473.8
(22) Anmeldetag: 15.11.2019
(51) Int. Cl.: G01R 33/383, G01R 33/387, H01F 7/02

(54) **HALBACH-MAGNETANORDNUNG MIT AUSNEHMUNG**
HALBACH MAGNETIC ASSEMBLY WITH NOTCH
DISPOSITIF MAGNÉTIQUE HALBACH POURVU D'ENCOCHE

(30) Priorität: 23.11.2018 DE 102018220170
(43) Veröffentlichungstag der Anmeldung: 27.05.2020
(73) Patentinhaber: Bruker BioSpin GmbH, 76287 Rheinstetten (DE)
(72) Erfinder: Pietig, Rainer, 76316 Malsch (DE); Niemann, Volker, 75228 Ispringen (DE); Hänichen, Lukas, 76137 Karlsruhe (DE)
(74) Vertreter: Kohler Schmid Möbus Patentanwälte

(56) Entgegenhaltungen:
- EP-A1- 3 382 412
- US-A- 4 931 760
- MENZEL KATHARINA ET AL: "Dipolar openable Halbach magnet design for High-Gradient Magnetic Filtration", SEPARATION AND PURIFICATION TECHNOLOGY, ELSEVIER SCIENCE, AMSTERDAM, NL, Bd. 105, 26. Dezember 2012 (2012-12-26), Seiten 114-120, XP028964621, ISSN: 1383-5866, DOI: 10.1016/J.SEPPUR.2012.12.019
- BERNHARD BLÜMICH ET AL: "Small-scale instrumentation for nuclear magnetic resonance of porous media", NEW JOURNAL OF PHYSICS, Bd. 13, 28. Januar 2011 (2011-01-28), Seiten 1-15, XP055577372, DOI: 10.1088/1367-2630/13/1/015003

## Beschreibung

Die Erfindung betrifft eine Magnetanordnung für eine Magnetresonanz-Apparatur mit einem Permanentmagnetsystem zur Erzeugung eines homogenen Magnetfeldes B₀ in Richtung senkrecht zu einer z-Achse in einem Messvolumen, wobei das Permanentmagnetsystem mindestens ein konzentrisch um die z-Achse angeordnetes, hohlzylinderförmiges ringförmiges Magnetelement aus magnetischem Material mit einer axialen Länge L_{z,M} und einem Innenradius Rᵢₙ umfasst, wobei das ringförmige Magnetelement aus einzelnen Magnetsegmenten aufgebaut und so angeordnet ist, dass es eine Halbach-Magnetisierung aufweist, die ein magnetisches Dipolfeld erzeugt.

Eine solche Magnetanordnung ist bekannt aus der US 4,931,760 A (=Referenz [1]) oder aus der US 2010/013473 A1 (=Referenz [2]).

### Hintergrund der Erfindung

Die vorliegende Erfindung betrifft allgemein den Bereich des Magnetbaus, insbesondere des Designs und der Herstellung von Magnetanordnungen. Des Weiteren befasst sich die Erfindung aber auch mit dem Gebiet der Magnetresonanz (="MR"), insbesondere die Bereitstellung von hierfür geeigneten Permanentmagnetsystemen in Halbach-Konfiguration, die zur Erzeugung von homogenen Magnetfeldern für NMR-Messungen bestimmt sind. Die Anwendbarkeit der Erfindung ist jedoch nicht auf diese Gebiete beschränkt.

Sowohl im Bereich der Kernresonanzspektroskopie (="NMR") als auch bei der bildgebenden Anwendung (="MRI") wird in einem zu definierenden Probenvolumen ein sehr homogenes und zeitlich konstantes Magnetfeld benötigt, welches mit resistiven oder supraleitenden Spulen oder einer geeigneten Permanentmagnetanordnung erzeugt werden kann. Die Verwendung von Permanentmagneten wird bevorzugt, wenn Flussdichten von unterhalb 2T ausreichend sind und ein vergleichsweise kompakter Aufbau erwünscht ist.

Benchtop-NMR-Geräte benötigen ein hochgradig homogenes Magnetfeld, welches zum einen mit einer Magnetspulenanordnung, aber auch mit einer Permanentmagnetanordnung erzeugt werden kann.

Eine streufeldarme Permanentmagnetanordnung für MR-Apparaturen mit Polschuh- und Joch-Elementen zur Rückführung des und Bündelung des magnetischen Flusses in teilweise segmentierter, ringförmiger Geometrie ist etwa aus der EP 3 217 186 B1 (=Referenz [3]) bekannt. Hierbei handelt es sich allerdings gerade *nicht* um eine gattungsgemäße Halbach-Konfiguration, sondern um einen "klassischen", geschlossenen Joch-basierten Magneten. Als Führungsschienen und/oder Montagehilfen können hier umlaufende Nuten an der äußeren Mantelfläche des mittleren Trommelelements vorgesehen sein.

Das Joch-freie Halbach-Design ist eine gänzlich andere bekannte Anordnung, welche aber ebenfalls für diesen Zweck verwendet werden kann. Die Verwendung von ringförmigen Permanentmagneten mit einer Magnetisierung als Halbach-Dipol ist im Stand der Technik beschrieben (siehe etwa Referenzen [1] oder [2]).

In der Theorie können mit diesen Magnetanordnungen auch die für NMR Messungen erforderliche hohe Feld-Homogenität erzielt werden, jedoch ist es gerade bei Magnetringen in Halbachkonfiguration recht schwierig, ein derart homogenes B₀ Feld zu erzeugen. Typischerweise werden ringförmige Halbach-Dipole derart aufgebaut, dass einzelne Magnetsegmente mit variierenden Magnetisierungsrichtungen aneinandergefügt werden, wobei sich die Magnetisierungsrichtung im Azimutwinkel verändert.

Um die für NMR-Messungen geforderte Feldhomogenität im Messvolumen zu erreichen, müssen bei den Halbach-Magneten Korrektur-mechanismen vorgesehen werden, um Toleranzen des Magnetmaterials oder der Position der einzelnen Magnetblöcke ausgleichen zu können, was den mechanischen Aufbau verkompliziert. Diese Thematik wird in US 2010/013473 A1 (=Referenz [2]) adressiert.

Die US 2015/0061680 A1 (=Referenz [4]) beschreibt Magnetanordnungen und Verfahren zum Erzeugen von Magnetfeldern. Sie umfasst Magnetanordnungen mit einer Mehrzahl von polyedrischen Magneten, die in einer Gitterkonfiguration angeordnet sind und zumindest teilweise ein Testvolumen umschließen, wobei die Magnetanordnung ein zugeordnetes Magnetfeld mit einer bestimmten Feldrichtung aufweist. Die Magnetisierungsrichtung der einzelnen Polyedermagneten und deren Anordnung ist dergestalt, dass das entstehende magnetische Feld eine Halbachkugel approximiert. Das Feld des Grundmagneten nach dem hier beschriebenen Verfahren ist im Allgemeinen nicht homogen und somit für MR-Anwendungen ungeeignet.

In der eingangs zitierten US 2010/013473 A1 (=Referenz [2]) wird ein NMR Permanentmagnet vorgeschlagen mit einer Halbach-Architektur aus drei Ringen, wobei ein zentraler Magnetring axial von zwei Kopfringen flankiert wird. Die Ringe sind zum Zwecke der Feldhomogenisierung gegenseitig in Längsrichtung mittels Schrauben oder Gewindemuttern verschiebbar. In Referenz [2] ist weiterhin offenbart, dass die Ringe aus Einzelsegmenten bestehen, die abwechselnd trapezförmig und rechteckig sind, wobei die einzelnen Segmente zur Feldhomogenisierung in Radialrichtung verschiebbar sind. Während die Bohrung der drei Magnetringe längs der z-Achse überall einen identischen Innenradius Rᵢₙ aufweist, ist der Außenradius des zentralen kleiner als der derjenige der beiden flankierenden Kopfringe.

In ihrem Artikel "Dipolar openable Halbach magnet design for High-Gradient Magnetic Filtration" (=Referenz [5]) beschreiben MENZEL KATHARINA ET AL eine Magnetanordnung in einer Magnetresonanz-Apparatur mit einem Permanentmagnetsystem zur Erzeugung eines homogenen Magnetfeldes Bo in Richtung senkrecht zu einer z-Achse in einem Messvolumen, wobei das Permanentmagnetsystem mindestens ein konzentrisch um die z-Achse angeordnetes, hohlzylinderförmiges ringförmiges Magnetelement aus magnetischem Material mit einer axialen Länge LZ,M und einem Innenradius Rin umfasst, wobei das ringförmige Magnetelement aus einzelnen Magnetsegmenten aufgebaut und so angeordnet ist, dass es eine Halbach-Magnetisierung aufweist, die ein magnetisches Dipolfeld erzeugt, wobei das ringförmige Magnetelement eine um die z-Achse umlaufende durchgehende Ausnehmung aufweist, die symmetrisch zur Ebene z=0 angeordnet ist und deren axiale Ausdehnung Lz ,A geringer ist als die axiale Länge LZ,M des ringförmigen Magnetelements, wobei die umlaufende nutförmige Ausnehmung des ringförmigen Magnetelements eine radiale Tiefe T=TA sowie eine axiale Länge LZ,A < LZ,M zwischen den z-Positionen Z =-ZA bis Z =+ZA aufweist, und wobei die radiale Tiefe TA sowie die axiale Länge LZ,A der nutförmigen Ausnehmung so gewählt sind, dass die verbleibende Inhomogenität des homogenen Magnetfeldes Bo in einem vorgegebenen Messvolumen mit einer axialen Plateaulänge Lp im Zentrum der Magnetanordnung der Magnetresonanz-Apparatur 10ppm nicht überschreitet.

Die ebenfalls bereits eingangs zitierte US 4,931,760 A (=Referenz [1]) schließlich beschreibt auch einen Permanentmagneten in Halbach-Konfiguration zur Erzeugung eines homogenen Magnetfeld in MRI-Instrumenten. Um die Feldhomogenität zu erhöhen, wird vorgeschlagen, auf der äußeren Mantelfläche des ringförmigen Magnetelements in einem axialen Abstand +z₁ und -z₁ von der Ebene z=0 zwei Ausnehmungen mit jeweils geringerer radialer Dicke h₂ als beim restlichen Ring vorzusehen. Eine um die z-Achse umlaufende nutförmige, hohlzylindrische, symmetrisch um die Ebene z=0 herum angeordnete zentrale Ausnehmung ist jedoch nicht offenbart, erst recht nicht ein Vorschlag zur konkreten Dimensionierung einer solchen zentralen Nut.

### Aufgabe der Erfindung

Der vorliegenden Erfindung liegt demgegenüber die Aufgabe zugrunde, mit möglichst einfachen technischen Maßnahmen und ohne Volumenzunahme eine möglichst kompakte und leichtgewichtige Permanentmagnetanordnung der eingangs definierten Art für eine MR-Vorrichtung bereitzustellen, die -bei vorgegebener Feldstärke- über eine axiale Plateaulänge L_{P} im Zentrum der Magnetanordnung einen Bereich mit besonders homogener Feldverteilung erzeugt, wobei die äußeren Abmaße der Anordnung -also axiale Länge und radiale Breite- sowie deren Gewicht gegenüber den bekannten Halbach-Anordnungen deutlich reduziert ist.

### Kurze Beschreibung der Erfindung

Diese Aufgabe wird durch die vorliegende Erfindung auf ebenso überraschend einfache wie wirkungsvolle Weise dadurch gelöst, dass das ringförmige Magnetelement eine um die z-Achse umlaufende nutförmige, hohlzylindrische Ausnehmung aufweist, die symmetrisch zur Ebene z=0 angeordnet ist und deren axiale Ausdehnung L_{z,A} geringer ist als die axiale Länge L_{z,M} des ringförmigen Magnetelements, wobei die umlaufende nutförmige Ausnehmung des ringförmigen Magnetelements eine radiale Tiefe T=T_{A} sowie eine axiale Länge L_{z,A} < L_{z,M} zwischen den z-Positionen z=-z_{A} bis z=+z_{A} aufweist, und dass die radiale Tiefe T_{A} sowie die axiale Länge L_{z,A} der nutförmigen Ausnehmung so gewählt sind, dass die verbleibende Inhomogenität des homogenen Magnetfeldes B₀ in einem vorgegebenen Messvolumen mit einer axialen Plateaulänge L_{P} im Zentrum der Magnetanordnung der Magnetresonanz-Apparatur 10ppm nicht überschreitet.

Die Erfindung beinhaltet Anordnungen von einem oder mehreren Halbachringen mit dem Ziel ein möglichst starkes, besonders homogenes Magnetfeld in einem vordefinierten Messvolumen bei möglichst geringem Materialeinsatz zu erzeugen. Ein zentraler Vorteil des erfindungsgemäßen Designs ist die überaus einfache technische Umsetzung mittels einer zentralen Nut, deren konkrete geometrischen Abmaße aufgrund der erfindungsgemäßen Vorschrift je nach Bedarfssituation individuell berechnet werden.

Bei Halbachdipolringen mit k=2 treten grundsätzlich nebenzonalen (axiale) auch doppeltperiodische (tesserale) Feldordnungen auf. Für die Homogenitätsanforderungen bei Magnetresonanzanwendungen ist es notwendig, dass im Bereich des Messvolumens sowohl die zonalen (=on-axis) als auch die tesseralen (=off-axis) Terme verschwinden oder zumindest vernachlässigbar werden, sodass im Messvolumen keine Inhomogenitäten auftreten.

Die verbleibenden Inhomogenitäten mit Ordnungen kleiner oder gleich der Design-Ordnung sind dann auf mechanische Toleranzen und Material-Inhomogenitäten zurückzuführen und können mit bekannten Shim-Technologien korrigiert werden.

Jeder Halbachring besteht in der Regel aus einheitlichem Permanentmagnetmaterial, das allerdings bei verschiedenen Ringen unterschiedlich gewählt sein kann.

### Bevorzugte Ausführungsformen und Weiterbildungen der Erfindung

Ganz besonders bevorzugt ist eine Klasse von Ausführungsformen der erfindungsgemäßen Magnetanordnung, bei der die radiale Tiefe T_{A} sowie die axiale Länge L_{z,A} der nutförmigen Ausnehmung so gewählt sind, dass ein Halbachmagnet von mindestens 6. Ordnung entsteht, also alle zonalen Feldterme N bis N≤8 im Messvolumen der Magnetresonanz-Apparatur entlang einer axialen Plateaulänge L_{P} einen Wert von 10ppm nicht überschreiten, vorzugsweise ein Halbachmagnet von 8. Ordnung, also alle zonalen Feldterme bis N=10 einen Wert von 10ppm nicht überschreiten. Mit dieser Herangehensweise wird eine bedarfsgerechte Auslegung erleichtert. Dies bedeutet, dass man beim Magnetdesign gewichtsoptimiert arbeiten kann, da mit der nutförmigen Ausnehmung eine gute Homogenität erreicht wird, ohne dass die Ausführung unnötig aufwändig und daher in der Herstellung teurer als nötig wird.

Überraschender Weise werden bei diesen Designkriterien der erfindungsgemäßen Magnetanordnung mit einer Ausnehmung gemäß dieser Definition auch die doppeltperiodischen Feldordnungen vernachlässigbar, denn auch die doppeltperiodischen Feldordnungen < N werden einen Wert von 10ppm im Messvolumen MV entlang eines Plateau-Radius R_{P} nicht überschreiten. Durch diese Eigenschaft werden keine weiteren Korrekturmechanismen für diese Feldordnungen benötigt.

Vorzugsweise ist bei der erfindungsgemäßen Magnetanordnung nur eine einzige umlaufende nutförmige Ausnehmung beim ringförmigen Magnetelement vorhanden. Dies ist mit vertretbarem Konstruktionsaufwand problemlos möglich.

Weitere vorteilhafte Ausführungsformen sind dadurch gekennzeichnet, dass die umlaufende nutförmige, hohlzylindrische Ausnehmung als radial innenliegende Nut durch einen separaten zentralen Magnetring mit einer axialen Ausdehnung L_{z,A} und einem Innenradius Rᵢₙ+T_{A} ausgebildet ist, der axial beiderseits jeweils von einem weiteren Magnetring mit Innenradius Rᵢₙ flankiert ist. Durch geschickte Teilung muss die Nut also nicht durch Modifikation von Ringbaugruppen hergestellt werden, sondern entsteht einfach durch die radiale Abstufung benachbarter Ringbaugruppen. Die vergleichsweise niedrige Bauteilkomplexität der einzelnen Ringbaugruppen (Kreisringe) bleibt also erhalten.

Die Magnetisierungsrichtung der Einzelsegmente im ringförmigen Magnetelement kann bei Ausführungsformen der Erfindung im Wesentlichen parallel in einer zur z-Richtung senkrechten x-y-Ebene verlaufen, wobei optional ebene Ausführung der Halbach-Anordnung oder wahlweise auch ein 3dimensionaler Halbachmagnet vorgesehen sein kann. Ein 3dimensionaler Halbachmagnet ist dadurch charakterisiert, dass die Magnetisierungsrichtung der ringförmigen Magnetelementen von der x-y-Ringebene derart abweicht, dass die zur Ringebene senkrechte Komponente mit dem Azimutalwinkel des jeweiligen ringförmigen Magnetelements um einen Kippwinkel variiert. Durch die Einführung dieses zusätzlichen Kippwinkels für die Magnetisierungsrichtung relativ zur x-y- Ebene lässt sich der Materialeinsatz bei gleichbleibender Homogenität weiter reduzieren, d.h. es sind noch effizientere Magnet-Designs möglich.

Eine weitere vorteilhafte Ausführungsform sieht vor, dass mehrere ringförmige Magnetelemente konzentrisch um die z-Achse angeordnet sind, von denen zumindest eines eine um die z-Achse umlaufende nutförmige, hohlzylindrische Ausnehmung aufweist. Eine solche radiale Stückelung kann Vorteile für die Herstellung haben. Außerdem wird beispielsweise ermöglicht, im Bereich kleinerer Radien auf hoch-koerzitives Material zurückzugreifen, um den höheren Entmagnetisierungskräften Rechnung zu tragen.

Diese Ausführungsform kann vorteilhaft dadurch weitergebildet werden, dass die axialen Längen L_{z,M1...Mn} der n ringförmigen Magnetelemente unterschiedlich sind, vorzugsweise von radial innen nach radial außen ansteigend. Dadurch werden weitere geometrische Freiheitsgrade eingeführt, die für die Optimierung zur Verfügung stehen.

Eine bevorzugte Ausführungsform der Erfindung ist dadurch gekennzeichnet, dass mehrere ringförmige Magnetelemente in z-Richtung übereinander gestapelt angeordnet sind, von denen zumindest eines eine um die z-Achse umlaufende nutförmige, hohlzylindrische Ausnehmung aufweist.

In der Praxis bewähren sich Weiterbildungen der beiden letztgenannten Ausführungsformen, die dadurch gekennzeichnet sind, dass zumindest einige der ringförmigen Magnetelemente aus unterschiedlichem, vorzugsweise jeweils permanent-magnetischem, Material aufgebaut sind, wobei insbesondere auch innerhalb eines einzelnen ringförmigen Magnetelements unterschiedliche Materialien vorhanden sein können. Im Bereich nahe des Zentrums ist die magnetische Feldstärke und damit die Entmagnetisierungskräfte maximal. Um eine permanente Entmagnetisierung zu vermeiden, kann man Material mit entsprechend höherer Koerzitivität verwenden, wo es erforderlich ist.

Ganz besonders bevorzugt sind Ausführungsformen der Erfindung, bei denen eine Einrichtung zur Homogenisierung des Magnetfelds, vorzugsweise ein Shim-Rohr, zum Shimmen der höheren Feldordnungen vorhanden ist. Die im Vorfeld beschriebenen Mechanismen werden auf diese Weise um ein weiteres noch präziseres Instrument zur Homogenisierung ergänzt. Damit sind noch feiner auflösende Korrekturen möglich.

Durch passive Shimelemente kann die Homogenität im Inneren der Magnetbohrung, insbesondere in einem Shimrohr deutlich verbessert werden. Außerdem kann auch eine Verbesserung der Homogenität durch elektrische Shimspulen im Inneren der Bohrung erreicht werden.

In den Rahmen der vorliegenden Erfindung fällt auch ein Verfahren zur Berechnung einer Magnetanordnung gemäß der oben beschriebenen Ausführungsformen oder ihren Weiterbildungen, umfassend folgende Schritte:
(a) Vorgeben eines minimalen Innenradius Rin der Magnetanordnung, welcher die Größe der Bohrung definiert, sowie einer kleinsten nichtverschwindenden zonalen Feldordnung N, wobei N eine positive gerade Zahl ist, sowie der gewünschten Ziel-Magnetfeldstärke des homogenen Magnetfeldes B₀ im Zentrum der Magnetanordnung;
(b) Entwerfen eines ringförmiges Magnetelements als Grundmagnetzylinder in Halbach-Konfiguration mit vorgegebenem Magnetmaterial bekannter Remanenz, mit einem maximalen Außenradius Rₒᵤₜ und einer axialen Länge L_{z,M}, wobei das Verhältnis des Außenradius Rₒᵤₜ zur Länge des Grundmagnetzylinders Rₒᵤₜ/L_{z,M} von 10:1 bis 1:10 beträgt, vorzugsweise 3:1 bis 1:3, sodass die Zielmagnetfeldstärke B₀ im Zentrum erreicht wird;
(c) Erfassen des resultierenden Magnetfeldprofils im Bereich des Messvolumens (MV) durch Bestimmung der Werte der zonalen Magnetfeldordnungen des Grundmagnetzylinders bis mindestens zur N-ten Ordnung;
(d) rechnerische Anordnung mindestens einer umlaufenden nutförmigen, hohlzylindrischen Ausnehmung im Grundmagnetzylinder symmetrisch zur Ebene z=0 mit einer niedrigeren Remanenz und Berechnen der radialen Tiefe T_{A} sowie der axialen Länge L_{z,A} < L_{z,M} zwischen den z-Positionen z=-z_{A} bis z=+z_{A} und mit L_{N} derart, dass die Summe der zonalen Magnetfeldordnungen mit Ordnung kleiner N bei dem durch die Ausnehmung modifizierten Grundmagnetzylinder verschwindet;
(e) Anpassen der vom modifizierten Grundmagnetzylinder erzeugten Magnetfeldstärke im Zentrum der Magnetanordnung auf die gewünschte Magnetfeldstärke B₀ durch Verändern des Außenradius Rₒᵤₜ und/oder der axialen Länge L_{z,M} des Grundmagnetzylinders.

Das Entwerfen des Magnetelements in Schritt (b) ist durch Optimierung mittels Computerprogrammen ausführbar, die dem Fachmann üblicherweise verfügbar sind. Die Verhältnisse Rₒᵤₜ: L_{M} sind zunächst erst einmal willkürlich gewählt. Das Erfassen in Schritt (c) kann ein physikalischer Messschritt sein, was in der Regel jedoch nicht gut praktikabel ist. Vorzugsweise wird daher mit -der Fachwelt einschlägig bekannten-Algorithmen simuliert.

In Schritt (d) werden die ringförmig umlaufende Ausnehmung rechnerisch dargestellt. Diese Nut ist hier allgemein definiert, denn man kann sie ganz einfach durch Aussparen von Magnetmaterial des Grundrings herstellen ("Full Notch") oder durch Hinzufügen/Ersetzen eines zentralen Rings mit anderem magnetischem Material mit kleinerer Remanenz.

Auch dieser Schritt (d) kann durch verfügbare "Solver-Programme" erledigt werden. Der Solver kann bei den genannten Vorgaben eine Nut entwerfen, bei welcher die Summe aller geraden zonalen Ordnungen kleiner N verschwindet. Dabei ergibt sich ein äußerst vorteilhafter überraschender Effekt: Unter der Bedingung, dass ein zentraler umlaufender Bereich im Halbachring existiert, der die gleiche, jedoch negative Feldordnung B_{N} wie der Grundmagnetring aufweist, verschwinden die doppeltperiodischen Feldordnungen <N im Messvolumen ebenfalls. "Verschwinden" bedeutet in diesem Zusammenhang allerdings nicht, dass die Feldordnungen exakt gleich 0 sind. Die Feldordnungen werden aber so klein, dass sie nur noch einen wirklich vernachlässigbaren Beitrag zum Gesamtfeld liefern.

Bei einer vorteilhaften Variante des erfindungsgemäßen Verfahrens wird in Schritt (e) die aus Schritt (d) resultierende Feldstärke B_{0R} erfasst und der Zielmagnetfeldstärke B₀ im Zentrum der Magnetanordnung angepasst wird durch Wiederholen der Schritte (b) bis (d) solange, bis B_{0R}=B₀. Auf diese Weise läuft die Optimierungsrechnung besonders schnell und umfangreiche Parameterstudien werden ermöglicht.

In einer weiteren bevorzugten Verfahrensvariante wird in einem weiteren Verfahrensschritt (f) das ringförmige Magnetelement rechnerisch aus mindestens N+2 kreisbogenförmigen Magnetsegmenten aufgebaut. Dadurch wird sichergestellt, dass die durch die Segmentierung entlang des Umfangs auftretenden höheren Ordnungen bis einschließlich Ordnung N unterdrückt werden.

Vorteilhaft ist auch eine Verfahrensvariante, bei welcher die umlaufende nutförmige, hohlzylindrische Ausnehmung radial innen im Grundmagnetzylinder angeordnet ist, und dass der Außenradius R_{out,A} und der Innenradius R_{in,A} der Ausnehmung folgender Proportionalitätsbedingung gehorchen: (R_{in,A} + R_{out,A}) / (R_{in,A}) ∼ 1 + 0.003 * ((R_{in,A}) / (L_{P}))^{N}, wobei L_{P} die Plateaulänge des Messvolumens (MV) im Zentrum der Magnetanordnung, also die axiale Ausdehnung des Messvolumens (MV) bedeutet. Damit kann die Nut ganz einfach durch die radiale Abstufung benachbarter Ringbaugruppen mit relativ geringer Bauteilkomplexität hergestellt werden.

Eine weitere bevorzugte Verfahrensvariante zeichnet sich dadurch aus, dass die umlaufende nutförmige, hohlzylindrische Ausnehmung im Grundmagnetzylinder in einem separaten zentralen Magnetring mit einer axialen Länge L_{z,A} und einem Innenradius Rᵢₙ+T_{A} realisiert wird, sodass die Magnetanordnung mindestens drei koaxial entlang der z-Achse angeordnete Einzelringe umfasst. Die durch die Segmentierung entlang des Umfangs auftretenden höheren Ordnungen bis einschließlich Ordnung N können damit unterdrückt werden.

Ebenfalls bevorzugt ist eine Verfahrensvariante, bei welcher die kreisbogenförmigen Magnetsegmente zunächst zu festen Einzelringen verklebt und in z-Richtung übereinander gestapelt werden und zur weiteren Homogenisierung des Magnetfelds der separate zentrale Magnetring in einer zur z-Richtung senkrechten x-y-Ebene verschoben wird. Diese Vormontage zu starren Einzelbaugruppen hat unter anderem erhebliche Vorteile hinsichtlich der mechanischen Robustheit und Sicherheit der Anordnung.

Diese Variante kann noch zusätzlich verbessert werden, wenn die axial äußeren Magnetringe zur weiteren Homogenisierung des Magnetfelds relativ zueinander um die z-Achse verdreht und/oder verkippt werden. Durch die Einführung mechanischer Stellmechanismen können Störordnungen, die nicht konzeptionellen Ursprungs sind, sondern in den Unzulänglichkeiten der Herstellung begründet sind (etwa Fertigungstoleranzen und Schwankungen der Materialeigenschaften), problemlos ausgeglichen werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in den Figuren und Diagrammen der Zeichnung dargestellt und wird anhand von Ausführungsbeispielen näher erläutert.

Es zeigen:
- Fig.1: einen schematischen räumlichen Vertikalschnitt einer Ausführungsform der erfindungsgemäßen Magnetanordnung mit einem ersten radial inneren ringförmige Magnetelement mit umlaufender Innen-Nut, einem zweiten ringförmigen Magnetelement mit Innen-Nut, welches das erste Magnetelement umgibt, sowie einem das zweite Magnetelement radial umgebenden dritten Magnetelement ohne umlaufende nutförmige Ausnehmung;
- Fig. 2a: eine schematische Schnittdarstellung durch eine Hälfte einer besonders einfachen Ausführungsform mit einem Magnetelement und einer radial innenliegenden umlaufenden nutförmigen Ausnehmung;
- Fig. 2b: ein Magnetelement wie in Fig. 2a, aber mit einer radial außenliegenden umlaufenden nutförmigen Ausnehmung;
- Fig. 2c: ein Magnetelement wie in Fig. 2a mit einer radial innenliegenden umlaufenden nutförmigen Ausnehmung, jedoch aufgebaut aus drei Sub-Ringen mit einem zentralen, radial nach außen versetzten Magnetring, der beidseitig axial von zwei weiteren Magnetringen flankiert ist;
- Fig. 3a: eine schematische Schnittdarstellung durch beide Hälften einer Ausführungsform mit radial innenliegender umlaufender nutförmiger Ausnehmung wie in Fig. 2a;
- Fig. 3b: eine schematische Schnittdarstellung durch beide Hälften eines Magnetelements mit radial außenliegender umlaufender nutförmiger Ausnehmung wie in Fig. 2b;
- Fig. 3c: ein Magnetelement wie in Fig. 2c aufgebaut aus drei Sub-Ringen, wobei der zentrale Sub-Ring einen geringeren radialen Wanddurchmesser aufweist als die beiden flankierenden weiteren SubRinge;
- Fig. 4a: ein Magnetelement aus drei Subringen ähnlich wie in Fig. 3c, wobei der zentrale Magnetring aus zwei konzentrischen Ringen aufgebaut ist, die radial voneinander beabstandet sind;
- Fig. 4b: eine Ausführungsform mit einem Magnetelement aus drei Subringen ähnlich wie in Fig. 3c, jedoch zusätzlich mit einem konzentrisch zum diesem Magnetelement radial innen angeordneten weiteren Magnetelement ohne nutförmige Ausnehmung;
- Fig. 5: eine Ausführungsform mit drei axial übereinander gestapelten Magnetelementen, von denen nur das mittlere eine umlaufende, radial innenliegende nutförmige Ausnehmung aufweist;
- Fig. 6: räumliche Halbschnitte zur Veranschaulichung der Entstehung einer einfachen Ausführungsform des erfindungsgemäßen Magnetelements wie in den Figuren 2a und 3a gezeigt:
a) Ausgangs-Magnetring ohne Nut
b) gewünschte nutförmige Ausnehmung
c) Magnetelement mit entsprechender umlaufender, radial innenliegender nutförmiger Ausnehmung;
- Fig. 7: a) einen räumlichen Halbschnitt und
b) einen zugehöriger Vertikalschnitt
zur Veranschaulichung des Aufbaus einer Ausführungsform des erfindungsgemäßen Magnetelements aus 3 Sub-Ringen ähnlich den Ausführungsformen der Fign. 2c und 3c;
- Fig. 8a: einen räumlichen Halbschnitt durch eine Ausführungsform ähnlich wie in Fig. 5;
- Fig. 8b: einen räumlichen Halbschnitt durch eine Ausführungsform ähnlich wie in Fig. 8a, wobei das mittlere Magnetelement mit radial innenliegender nutförmiger Ausnehmung einen kleineren Außenradius aufweist als die beiden axial flankierenden Magnetelemente ohne Nuten;
- Fig. 9: einen räumlichen Halbschnitt durch eine Ausführungsform eines Magnetelement mit radial innenliegender nutförmiger Ausnehmung ähnlich wie in den Figuren 2a und 3a gezeigt, jedoch zusätzlich mit einem weiteren, radial außen angeordneten Magnetelement ohne Nut;
- Fig. 10: den B₀-Feldverlauf um z=0 mit einer Parabel 6. Ordnung und einer axialen Plateaulänge L_{P} im Zentrum der Magnetanordnung, wo die verbleibende Inhomogenität 10ppm nicht überschreitet;
- Fig. 11a: einen schematischen vertikalen Halbschnitt längs der z-Achse durch ein Magnetelement gemäß Ausführungsbeispiel 1;
- Fig. 11b: den Plateaubereich des Ausführungsbeispiels 1 von Fig. 11a;
- Fig. 12a: einen schematischen vertikalen Halbschnitt längs der z-Achse durch ein Magnetelement gemäß Ausführungsbeispiel 2;
- Fig. 12b: den Plateaubereich des Ausführungsbeispiels 2 von Fig. 12a;
- Fig. 13a: die normierte Magnetlänge L_{M}/Rᵢₙ als Funktion der normierten Plateaulänge Lₚ/Rᵢₙ bei einer einfachen Ausführungsform mit einem einzelnen Magnetelement mit Innennut zur Veranschaulichung der Feldabhängigkeit bei unterschiedlichen Remanenzen;
- Fig. 13b: die normierte Nutlänge L_{z}/Rᵢₙ als Funktion der normierten Plateaulänge Lₚ/Rᵢₙ zur Veranschaulichung der schwachen Abhängigkeiten von Feld und Plateaulänge bei unterschiedlichen Remanenzen;
- Fig. 13c: den normierten Außenradius des Magnetelements Rₒᵤₜ/Rᵢₙ als Funktion der normierten Plateaulänge Lₚ/Rᵢₙ zur Abschätzung der erforderlichen Baugröße des Magnetelements und zur Veranschaulichung der schwachen Abhängigkeit von Außenradius und Plateaulänge bei unterschiedlichen Remanenzen;
- Fig. 13d: den normierten Außenradius der umlaufenden Ausnehmung R/Rᵢₙ als Funktion der normierten Plateaulänge Lₚ/Rᵢₙ bei unterschiedlichen Remanenzen zur Veranschaulichung der schwachen Abhängigkeiten von Feld und Plateaulänge; und
- Fig. 13e: das normierte Volumen des Magnetelements V/Rᵢₙ³ als Funktion der normierten Plateaulänge Lₚ/Rᵢₙ bei unterschiedlichen Remanenzen zur Veranschaulichung der zunehmenden Abhängigkeit von Feld-und Plateaulänge bei axial kürzeren Magnetelementen und damit der Bedeutung der erfindungsgemäßen umlaufenden nutförmigen hohlzylindrischen Ausnehmung gerade bei kompakterem Magnet-Design.

Die erfindungsgemäße **Magnetanordnung 1**, wie sie in der Zeichnung in verschiedenen Ausführungsformen jeweils schematisch dargestellt ist, findet ihre Hauptanwendung als Bestandteil einer -in der Zeichnung nicht eigens gezeigten- Magnetresonanz-Apparatur mit einem Permanentmagnetsystem zur Erzeugung eines homogenen Magnetfeldes B₀ in Richtung senkrecht zu einer z-Achse in einem **Messvolumen 0,** wobei das Permanentmagnetsystem mindestens ein konzentrisch um die z-Achse angeordnetes, hohlzylinderförmiges ringförmiges **Magnetelement 2a; 2b; 2c; 2d; 2e; 2f'; 2f"** aus magnetischem Material mit einer axialen Länge L_{z,M} und einem Innenradius Rᵢₙ umfasst, und wobei das ringförmige Magnetelement 2a-f" aus einzelnen Magnetsegmenten aufgebaut und so angeordnet ist, dass es eine Halbach-Magnetisierung aufweist, die ein magnetisches Dipolfeld erzeugt.

In der Theorie erzeugt ein Halbach-Magnet von unendlicher axialer Länge und perfekter Verteilung der Magnetisierung ein perfektes homogenes Magnetfeld. In der Praxis wird eine derartige Halbach-Anordnung jedoch aus Magnetsegmenten von endlicher Länge aufgebaut, von denen jedes eine homogene Magnetisierung aufweist. Eine solche Anordnung erzeugt freilich Feld-Inhomogenitäten, die teilweise dem Design immanent sind aufgrund der endlichen Länge der Magnetanordnung sowie der Segmentierung des Halbach-Rings. Zum Teil sind diese Inhomogenitäten aber auch auf mechanische Unzulänglichkeiten und inhomogene Eigenschaften des verwendeten magnetischen Materials zurückzuführen.

Die Design-intrinsischen Inhomogenitäten entstehen dadurch, dass das Feld zum Ende der Magnetbohrung hin abnimmt, was eine Feld-Variation über die Länge der Messprobe hervorruft. Um diese störende Feld-Variation niedrig zu halten, muss die axiale Länge des Halbach-Rings genügend groß gewählt werden, was dann aber zwangsläufig zu einem relativ hohen Gewicht der gesamten Magnetanordnung führt. Zusammen mit der erforderlichen magnetischen Abschirmung verursacht dies ein hohes Gewicht sowie eine große Bauhöhe der Magnetresonanz-Apparatur, insbesondere wenn ein starkes Magnetfeld B>1,8T angestrebt wird. Außerdem wird die Handhabung der Messprobe aufgrund der großen Bauhöhe der Apparatur nicht mehr bequem und ergonomisch.

Die vorliegende Erfindung schlägt daher die Schaffung von Halbach-Ringen vor, die von vornherein eine wesentliche höhere Grundhomogenität des erzeugten Magnetfelds bei gegebener axialer Länge der Anordnung erreichen. Dies wiederum führt dann auch zu einer beträchtlichen Reduktion der erforderlichen Bauhöhe und des Gewichts des Permanentmagnetsystems im Vergleich zu den eingangs diskutierten bekannten Anordnungen.

Erfindungsgemäß wird dies erreicht, indem das ringförmige Magnetelement 2a; 2b; 2d eine um die z-Achse **umlaufende nutförmige hohlzylindrische Ausnehmung 3a; 3b; 3d** aufweist, die symmetrisch zur Ebene z=0 angeordnet ist und deren axiale Ausdehnung L_{z,A} geringer ist als die axiale Länge L_{z,M} des ringförmigen Magnetelements 2a; 2b; 2d, wobei die umlaufende nutförmige Ausnehmung 3a; 3b; 3d des ringförmigen Magnetelements 2a; 2b; 2d eine radiale Tiefe T=T_{A} sowie eine axiale Länge L_{z,A} < L_{z,M} zwischen den z-Positionen z=-z_{A} bis z=+z_{A} aufweist. Die radiale Tiefe T_{A} sowie die axiale Länge L_{z,A} der nutförmigen Ausnehmung 3a; 3b; 3d sind so gewählt, dass die verbleibende Inhomogenität des homogenen Magnetfeldes B₀ in einem vorgegebenen Messvolumen 0 mit einer axialen Plateaulänge L_{P} im Zentrum der Magnetanordnung 1 der Magnetresonanz-Apparatur 10ppm nicht überschreitet.

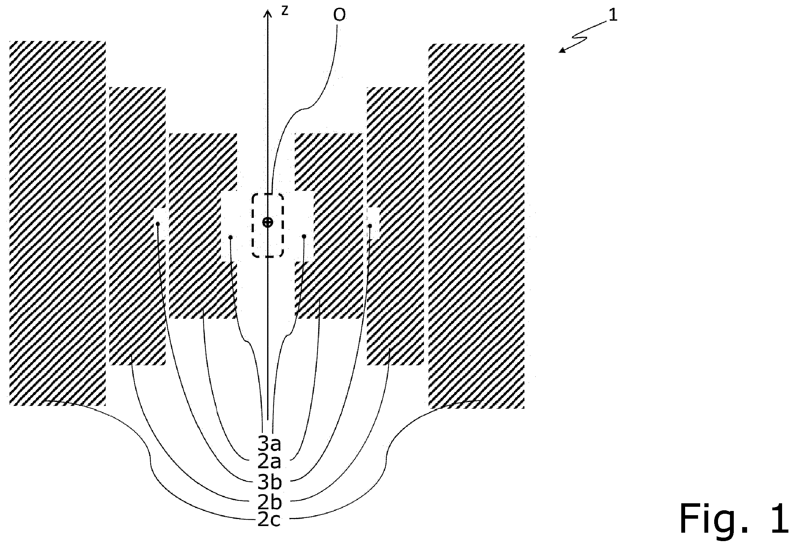

Das erfindungsgemäße Permanentmagnetsystem kann auch mehrere ringförmige Magnetelemente 2a; 2b; 2c; 2d; 2e aufweisen. In der in **Fig. 1** gezeigten Ausführungsform etwa sind diese konzentrisch um die z-Achse angeordnet. Zumindest eines dieser Magnetelemente muss dabei immer eine um die z-Achse umlaufende nutförmige, hohlzylindrische Ausnehmung 3a; 3b; 3d aufweisen. In der Ausführungsform gemäß Fig. 1 sind dies das radial innerste Magnetelement 2a und das zweit-innerste Magnetelement 2b.

Zumindest einige der ringförmigen Magnetelemente 2a; 2b; 2c; 2d; 2e; 2f'; 2f" können aus unterschiedlichem, vorzugsweise jeweils permanent-magnetischem, Material aufgebaut sein, wobei insbesondere auch innerhalb eines einzelnen ringförmigen Magnetelements 2a; 2b; 2c; 2d; 2e; 2f'; 2f" unterschiedliche Materialien vorhanden sein können.

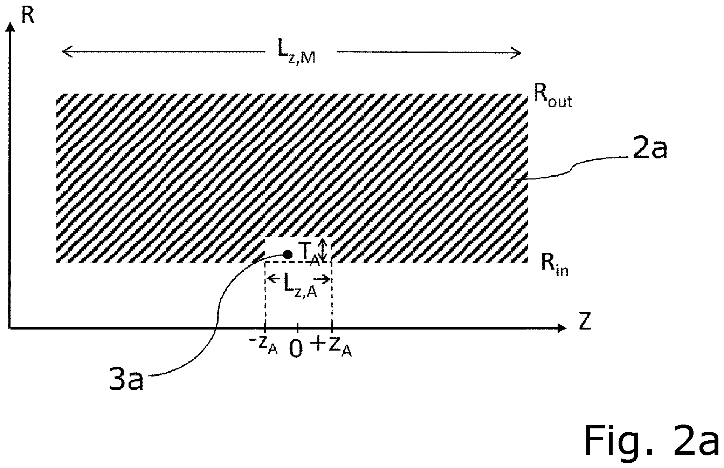

Eine besonders einfache Ausführung ist in **Fig. 2a** dargestellt. Hier besteht das Magnetelement 2a lediglich aus einem Hintergrundring, welcher definiert ist durch seinen Innenradius Rᵢₙ und seinen Außenradius Rₒᵤₜ sowie seiner axialen Länge L_{z,M}. Das Magnetelement 2a weist eine radial innen liegende nutförmige Aussparung 3a auf, die definiert ist durch ihre axiale Nutlänge L_{z,A} zwischen den z-Positionen z=-z_{A} bis z=+z_{A} sowie durch ihre radiale Tiefe T_{A}. Fig. 2a zeigt eine Schnittzeichnung eines solchen Magnetrings, wobei nur eine Hälfte davon zu sehen ist. Dies ist eine bevorzugte Ausführungsform, da man hier die Nut besonders klein dimensionieren kann und somit keine größeren Materialverluste hat, welche zu einer geringeren Gesamtfeldstärke führen würden.

Je weiter man sich von der ROI ("Region of Interest", bzw. Messvolumen) entfernt, um die Nut zu platzieren, desto größer muss die Nut dimensioniert werden, damit sie den Kriterien genügt, dass die niedrigen Feldordnungen < N verschwinden.

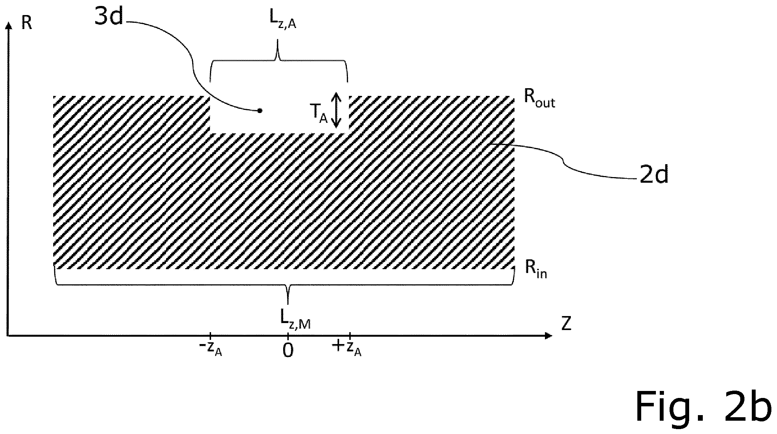

In **Fig. 2b** ist schematisch ein Magnetelement 2d gezeigt, bei welchem die nutförmige Ausnehmung 3d bezüglich der ROI *radial außen* am Grundmagnetring angebracht ist.

Zur Vereinfachung der Herstellung einer erfindungsgemäßen Magnetanordnung kann man auch so verfahren, dass die Aussparung im Magnetelement dadurch erzeugt wird, dass der Grundmagnet in Longitudinalrichtung längs der z-Achse in drei Einzelringe zerlegt oder sogar gleich aus drei solchen Einzelringen aufgebaut wird, wobei die Länge des axial mittleren Rings genau der-zuvor berechneten- axialen Länge L_{z,A} der nutförmigen Ausnehmung entspricht. Dieser axial mittlere Ring kann dann radial verschoben werden bis zum gewünschten Nutaußenradius.

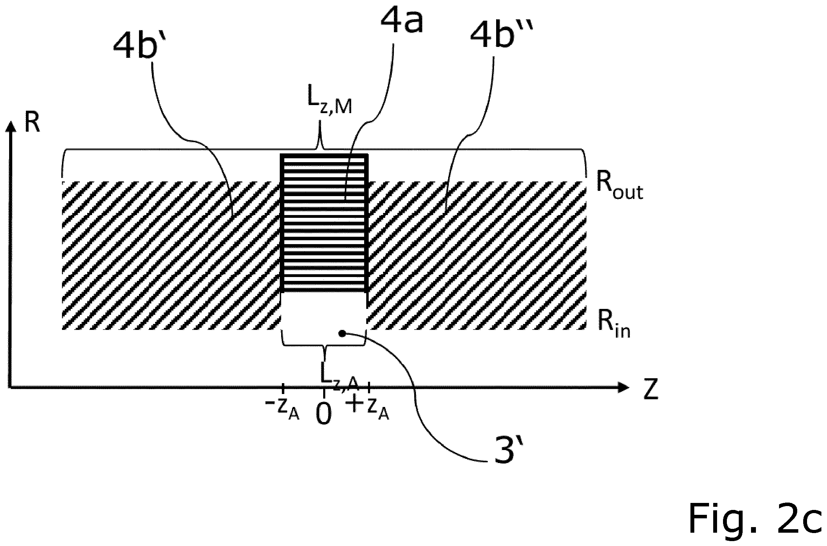

Eine solche Ausführungsform ist in **Fig. 2c** schematisch dargestellt. Dabei ist die umlaufende nutförmige, hohlzylindrische **Ausnehmung 3'** als radial innenliegende Nut durch einen separaten **zentralen Magnetring 4a** mit einer axialen Ausdehnung L_{z,A} und einem Innenradius Rᵢₙ+T_{A} ausgebildet. Dieser zentrale Magnetring 4a ist axial beiderseits jeweils von einem **weiteren Magnetring 4b', 4b"** mit Innenradius Rᵢₙ flankiert. Optional kann der mittlere Ring auch einen größeren Radius aufweisen. Das führt dann zu einem Gewinn an Gesamtfeldstärke, könnte allerdings radial weiter außen angeordneten weiteren Einzelringen oder anderen Bauteilen im Wege stehen.

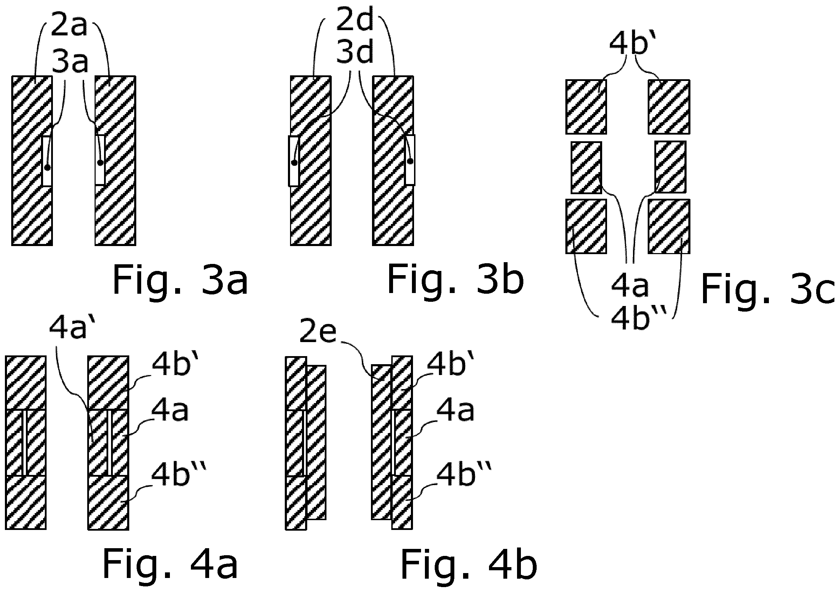

**Fig. 3a** zeigt beide Hälften eines Magnetelements 2a mit radial innenliegender umlaufender nutförmiger Ausnehmung 3a ähnlich wie in Fig. 2a.

**Fig. 3b** zeigt beide Hälften eines Magnetelements 2d mit radial außenliegender umlaufender nutförmiger Ausnehmung 3d ähnlich wie in Fig. 2b.

**Fig. 3c** zeigt ein Magnetelement aufgebaut aus drei Sub-Ringen mit einem zentralen, radial nach innen versetzten Magnetring 4a, der beidseitig axial von zwei weiteren Magnetringen 4b', 4b" flankiert ist, wobei der zentrale Sub-Ring 4a einen geringeren radialen Wanddurchmesser aufweist als die beiden flankierenden weiteren Sub-Ringe 4b', 4b".

**Fig. 4a** zeigt ein weiteres Magnetelement aus drei Subringen ähnlich wie in Fig. 3c, wobei der zentrale Magnetring aus zwei koaxialen Ringen 4a, 4a' aufgebaut ist, die radial voneinander beabstandet sind und somit einen umlaufenden nutförmigen Spalt zwischen sich einschließen.

**Fig. 4b** zeigt eine Ausführungsform mit einem Magnetelement aus drei Subringen 4a, 4b', 4b" ähnlich wie in den Figuren 2c oder 3c, jedoch zusätzlich mit einem konzentrisch zum diesem Magnetelement radial innen angeordneten weiteren Magnetelement 2e *ohne* nutförmige Ausnehmung. Der zentrale Magnetring 4a ist radial von dem Magnetelement 2e beabstandet und schließt somit einen umlaufenden nutförmigen Spalt zwischen dem zentralen Magnetring 4a und dem weiteren Magnetelement 2e ein.

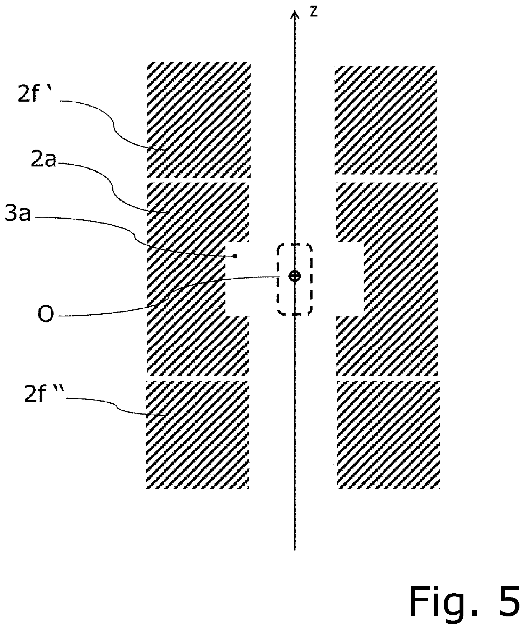

In **Fig. 5** ist eine Ausführungsform mit drei axial übereinander gestapelten Magnetelementen 2a, 2f', 2f" dargestellt, von denen nur das mittlere Magnetelement 2a eine um die z-Achse umlaufende, radial innenliegende nutförmige Ausnehmung 3a aufweist.

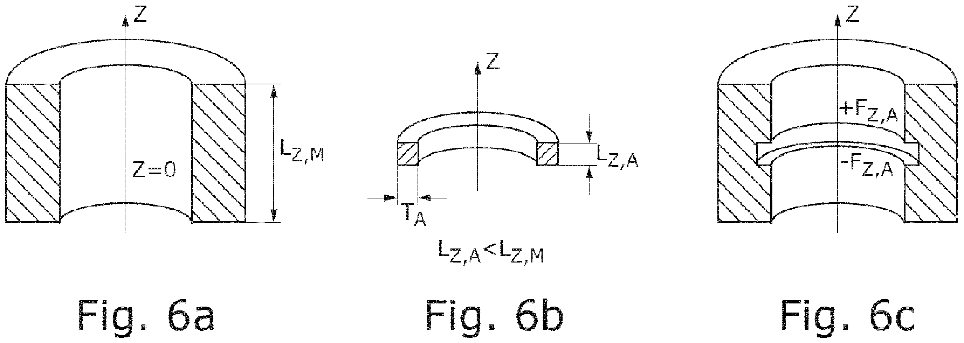

Die in den **Figuren 6a****-c** gezeigten räumlichen Halbschnitte dienen zur Veranschaulichung der Entstehung einer einfachen Ausführungsform des erfindungsgemäßen Magnetelements, wie etwa in den Figuren 2a und 3a dargestellt. Zunächst wird ausgegangen von einem einfachen Halbach-Magnetring ohne Nut, der eine axiale Länge L_{z,M} aufweist. Aus diesem wird dann die gewünschte -zuvor mit einem Design-Programm berechnetenutförmige Ausnehmung in Form eines kleineren Rings der axialen Länge L_{z,A} < L_{z,M} herausgetrennt. Auf diese Weise entsteht ein erfindungsgemäßes Magnetelement mit einer entsprechenden umlaufenden, radial innenliegenden nutförmigen Ausnehmung.

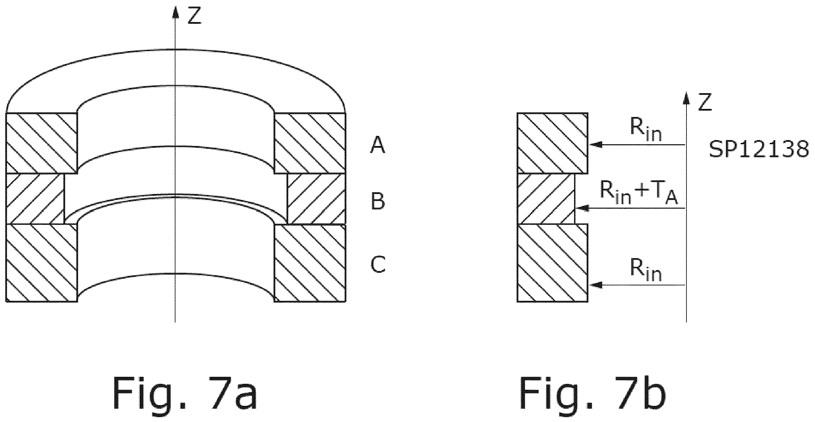

Der räumliche Halbschnitt von **Fig. 7a** und dessen zugehöriger Vertikalschnitt in **Fig. 7b** dienen der Veranschaulichung des Aufbaus einer Ausführungsform des erfindungsgemäßen Magnetelements aus drei Sub-Ringen ähnlich den Ausführungsformen der Figuren 2c und 3c.

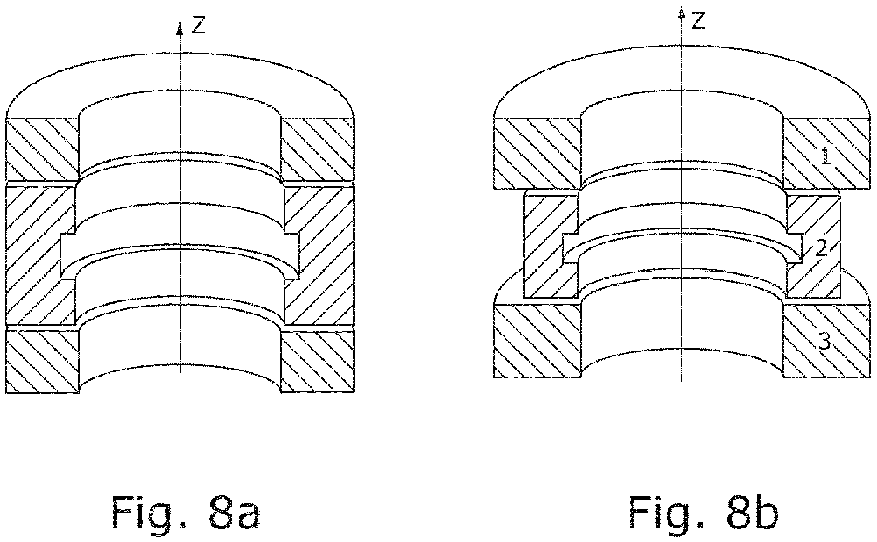

**Fig. 8a** zeigt anschaulich einen räumlichen Halbschnitt durch eine Ausführungsform ähnlich wie in Fig. 5.

In **Fig. 8b** ist eine Ausführungsform ähnlich wie in Fig. 8a dargestellt, bei welcher jedoch das zentrale axial mittlere Magnetelement mit radial innenliegender nutförmiger Ausnehmung einen *kleineren Außenradius* aufweist als die beiden axial flankierenden Magnetelemente ohne Nuten. Diese Maßnahme dient einer weiteren Homogenisierung des Magnetfelds im Messvolumen sowie einer zusätzlichen Materialeinsparung und damit Gewichtsreduzierung.

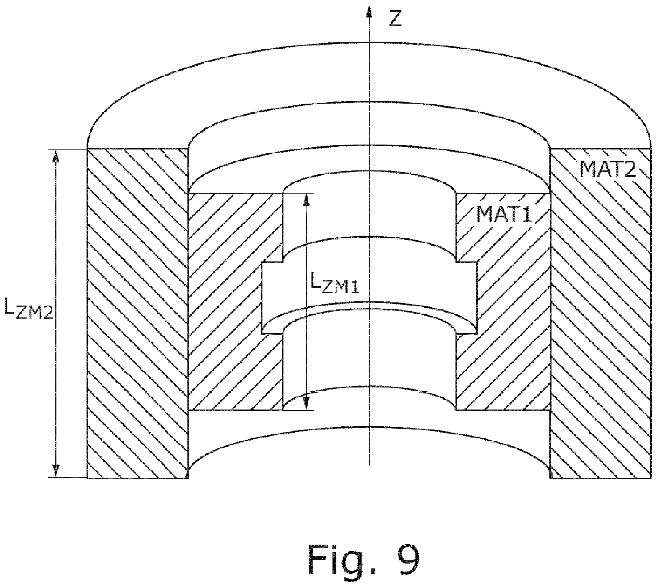

**Fig. 9** veranschaulicht als räumlicher Halbschnitt eine weitere Ausführungsform des erfindungsgemäßen Magnetelements mit radial innenliegender nutförmiger Ausnehmung ähnlich wie in den Figuren 2a und 3a, jedoch zusätzlich mit einem radial darum herum angeordneten Magnetelement ohne Nut und mit größerer axialer Länge.

Grundsätzlich gilt für alle Ausführungsformen der erfindungsgemäßen Magnetanordnung, dass die umlaufende Ausnehmung als sogenannte "Full-Notch", also um eine Aussparung im Hintergrundring ausgeführt sein kann. Die Ausnehmung kann aber auch durch einen Bereich mit reduzierter Remanenz gebildet sein, wobei die Aussparung beispielsweise mit einem anderen Magnetmaterial gefüllt ist.

Prinzipiell ist auch eine durchgängige Ausnehmung denkbar, aber nicht Gegenstand der Erfindung. Dann ergeben sich nur zwei spiegelbildliche Ringe in "Helmholtz-Anordnung". In der Vorgehensweise zur Berechnung der Ausnehmung sind sich beide Ausführungsformen ähnlich: Zunächst wird ein Hintergrundring mit einer gewünschten Remanenz definiert. Von diesem Hintergrund wird dann die Ausnehmung, welche im Rechenvorgang nichts anderes als ein "inverser Ring" ist, abgezogen. Handelt es sich um eine "Full-Notch", so muss ein entsprechender Ring, der dieselbe Remanenz wie der Hintergrundring hat, rechnerisch abgezogen werden. Handelt es sich um einen Ring mit einem vom Grundring unterschiedlichen Magnetmaterial, so muss ein entsprechender Ring mit der "Differenz-Remanenz" -also Remanenz des Hintergrundrings minus Remanenz der Ausnehmung- abgezogen werden. Die Differenz für die jeweilige Feldordnung muss am Ende der Berechnung vernachlässigbar sein.

Als vernachlässigbar werden die Feldordnungen dann angesehen, wenn sie kleiner als ein selbst definierter Wert werden. Setzt man beispielsweise eine 10ppm-Profillänge von 22mm an, so trägt die n-te Feldordnung mit 10⁶ * Bₙ/B₀ * (11mm)ⁿ ppm bei. Ist dieser Wert kleiner als 10ppm, so kann die entsprechende Feldordnung als "vernachlässigbar" adressiert werden.

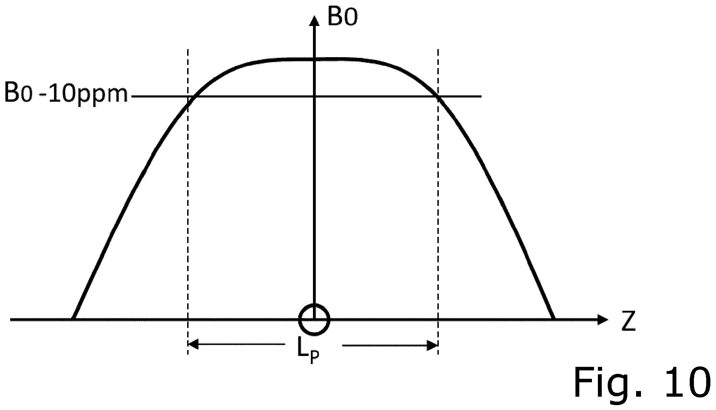

Das B₀-Feld entlang eines Nutzvolumens L_{P} (=Plateaulänge) im Zentrum des Magneten gilt dann als (hinreichend) homogen, wenn die Feldänderungen in z-Richtung nicht mehr als 10ppm abweicht, wie in **Fig. 10** dargestellt ist, die den B₀-Feldverlauf um z=0 mit einer Parabel 6. Ordnung und einer axialen Plateaulänge L_{P} im Zentrum der Magnetanordnung zeigt, wo die verbleibende Inhomogenität 10ppm nicht überschreitet.

Diese Homogenitätsanforderungen werden üblicherweise erfüllt, wenn ein Halbach-Magnetring 6. Ordnung (N=8) aufgebaut wird und erfindungsgemäß mit einer umlaufenden Aussparung versehen wird. Für Magneten mit höherer Ordnung, beispielsweise 8. Ordnung (N=10), ist es vorteilhaft, mindestens zwei Aussparungen anzubringen. Mit einer weiteren Aussparung erhöht man die Freiheitsgrade im Design und in der Fertigung. Verbleibt man bei nur einer Aussparung, so ist eine erhebliche Präzision bei der Fertigung erforderlich, was wiederum einen Mehraufwand bedeutet. Vorzugsweise werden für diese Permanentmagnetanordnung auch drei konzentrisch angeordnete Grundringe verwendet (siehe etwa die Ausführungsform von Fig. 1).

### Ausführungsbeispiel 1:

### Magnet mit einer 10ppm-Profillänge von 22mm in der ROI

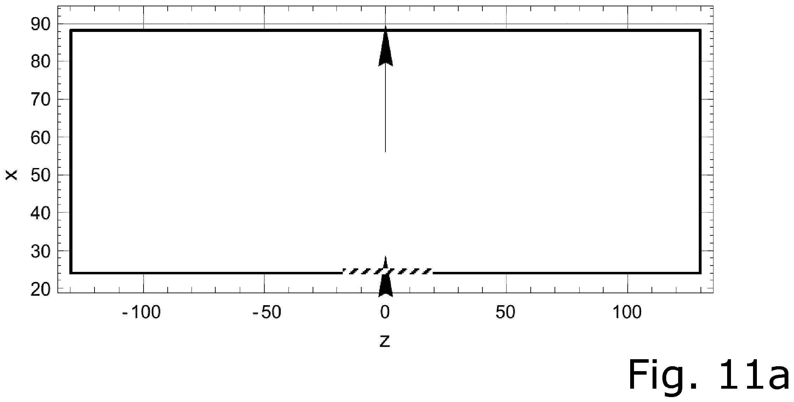

Das Design eines solchen Magneten aus Nd-Fe-B ist optimiert auf einen 10ppm-Bereich, der sich über 22mm in z-Richtung erstreckt bezüglich der Mitte des Magneten. In **Fig. 11a** ist eine Schnittzeichnung einer Hälfte des Magneten in der x-z-Ebene zu sehen. Die Nut ist in schraffiert dargestellt und mittig bezüglich z=0 angeordnet. Die x-Achse ist in dieser Darstellung gleichzusetzen mit dem Radius des Magnetelements. Die z-Achse der Anordnung läuft hier von -130mm bis +130mm.

Die Vorgaben beim Design dieses Magneten sind die resultierende Feldstärke B₀ im ROI, der Innenradius Rᵢₙ sowie die Forderung, dass der 10ppm-Bereich sich über mindestens 22mm erstrecken soll. Es wird auch eine nutförmige Aussparung definiert, die sich axial von der Mitte bei z=0 aus in z-Richtung und radial mit einem Außenradius R_{N} erstreckt. Des Weiteren sollen die Feldordnungen N< 8 minimal werden.

Um die Parameter etwas zu beschränken, damit das Solver-Programm sinnvolle Ergebnisse liefert, ist es möglich, noch eine etwaige Länge L_{M} des Magneten einzugeben. Der Solver liefert dann eine numerische Näherungslösung für die Dimension des Magneten und der Nut.

In der Tabelle unten sind die Dimensionen des Magnetrings angegeben. Die hier berechneten axialen Feldordnungen sind vernachlässigbar klein. Überraschend ist insbesondere, dass die doppelperiodischen Terme auch verschwindend klein werden.

| Parameter | Ring | Nut |
|---|---|---|
| B₀ [T] | 1,8 | |
| Rᵢₙ [mm] | 24 | 24 |
| Rₒᵤₜ [mm] | 88,2593 | |
| Rₙ [mm] | | 24,112 |
| Lₘ [mm] | 259,802 | |
| L_{N} [mm] | | 35,5198 |
| Masse [g] | 44153,8 | |

### Gradienten des Gesamtmagneten:

Axial [(T/m)^{N}]:
   B₀ 1,8
   B₂ -4,60786 × 10⁻¹⁹
   B₄ 1,42895 × 10⁻²²
   B₆ -9 × 10⁻¹²
Doppeltperiodisch [(T/m)^{N}]:
   B₂₂ 3,84341 × 10⁻²⁰
   B₄₂ -4,76275 × 10⁻²⁴
   B₆₂ 1,60714 × 10⁻¹³

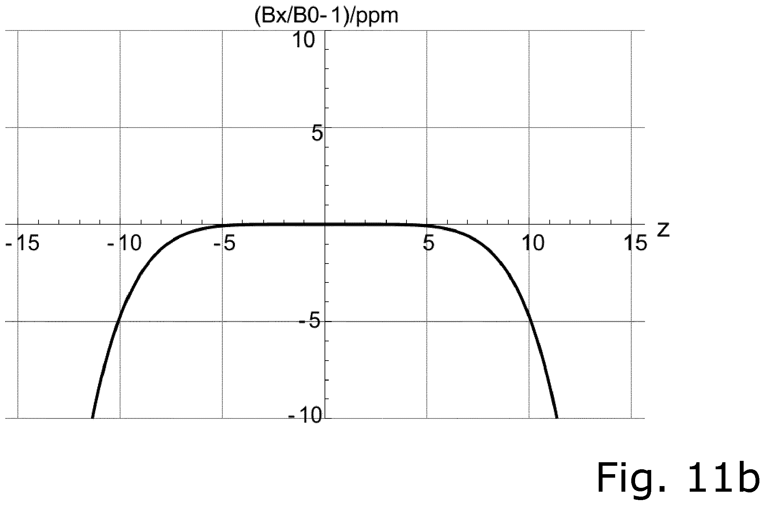

In der Grafik von **Fig. 11b** ist deutlich zu erkennen, dass sich der 10ppm-Bereich axial über mehr als 22mm in z-Richtung erstreckt.

### Ausführungsbeispiel 2:

### Gewichtsoptimierter Magnet mit B₀ = 1,8T Feldstärke

Das Design dieses Magneten aus Nd-Fe-B ist optimiert auf eine Minimierung des Magnetgewichts bei derselben Feldstärke wie im Ausführungsbeispiel 1, jedoch wurde ein Kompromiss gemacht hinsichtlich des 10ppm-Bereich, der sich nunmehr axial lediglich über etwa 15mm in z-Richtung erstreckt bezüglich der Mitte des Magneten bei z=0.

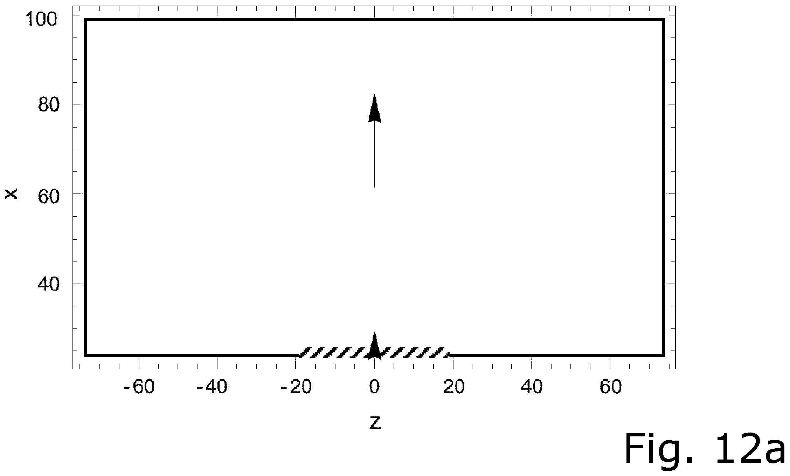

In **Fig. 12a** ist eine Schnittzeichnung in xz-Ebene einer Hälfte des Magnetelements zu sehen. Die Nut ist wieder schraffiert dargestellt und mittig um z=0 angeordnet. Die x-Achse ist in dieser Darstellung gleichzusetzen mit dem Radius des Magnetelements. Die z-Achse läuft hier von -75mm bis +75mm.

Die Vorgaben beim Design dieses Magneten sind die resultierende Feldstärke B₀ im ROI, der Innenradius Rᵢₙ sowie die Forderung, dass das Gewicht minimal werden soll. Es wird auch eine Nut definiert, die sich axial von der Mitte bei z=0 aus in z-Richtung und radial mit einem Außenradius R_{N} erstreckt. Des Weiteren sollen die Feldordnungen N < 8 minimal werden. Die Länge des 10ppm-Bereichs steht hier nicht im Fokus.

Die Einengung bestimmter Parameter wie die Länge L_{M} des Magneten ist auch hier möglich. Der Solver liefert dann eine numerische Näherungslösung für die Dimension des Magneten und der Nut.

In der Tabelle unten sind die Dimensionen und Gradienten des resultierenden Magnetrings aufgelistet. Überraschend ist auch hier wiederum, dass die doppelperiodischen Terme verschwindend klein werden.

| Parameter | Ring | Notch |
|---|---|---|
| B₀ [T] | 1,8 | |
| Rᵢₙ [mm] | 24 | 24 |
| Rₒᵤₜ [mm] | 99,027 | |
| Rₙ [mm] | | 25,337 |
| L_{M} [mm] | 147,2234 | |
| L_{N} [mm] | | 37,1538 |
| Masse [g] | 31961,1 | |

### Gradienten des Gesamtmagneten:

Axial [(T/m)^{N}]:
   B₀ 1,8
   B₂ -5,42101 × 10⁻²⁰
   B₄ 1,43929 × 10⁻²²
   B₆ -8,67116 × 10⁻¹¹
Doppeltperiodisch [(T/m)^{N}]:
   B₂₂ 5,0822 × 10⁻²¹
   B₄₂ -4,80799 × 10⁻²⁴
   B₆₂ 1,54842 × 10⁻¹²

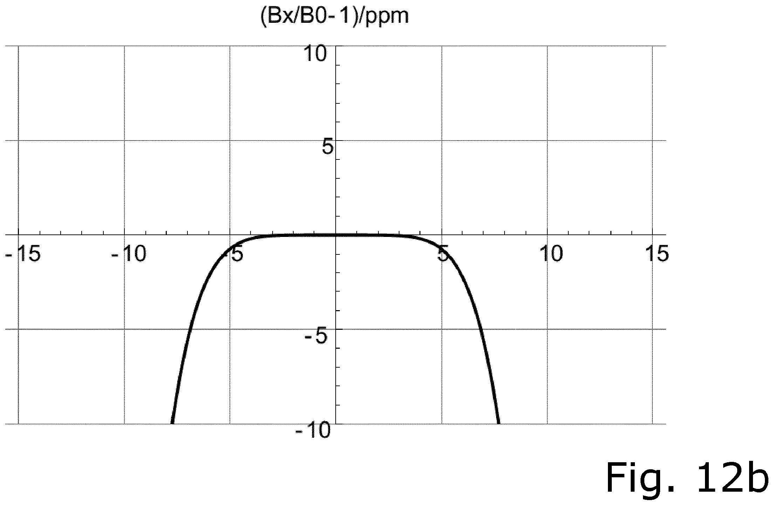

In der Grafik von **Fig. 12b** ist deutlich zu erkennen, dass der 10ppm-Bereich kleiner ist als im Ausführungsbeispiel 1.

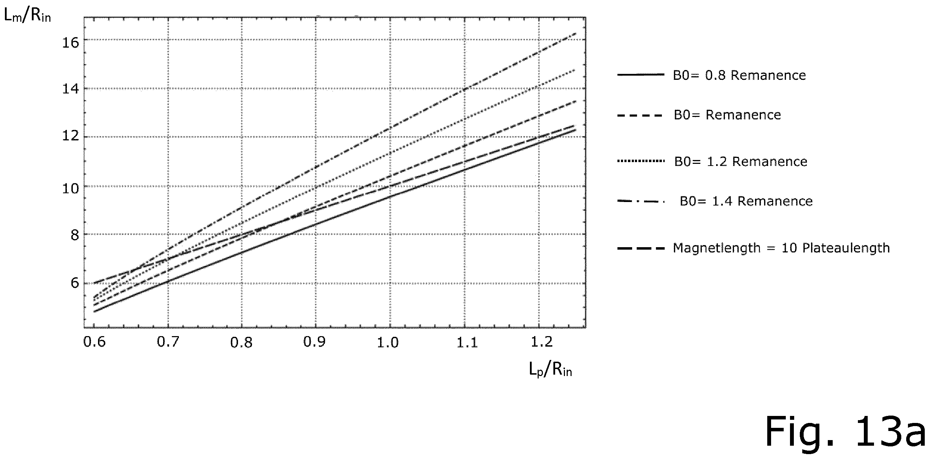

Die Grafiken der Figuren 13a-e basieren auf der Annahme einer Minimalausführung, also einem hohlzylindrischen HALBACH-Magnet mit einer zentralen, innenliegenden Nut gemäß Fig. 2a. Dabei werden Längengrößen auf den Bohrungsradius Rᵢ normiert, Volumengrößen auf die dritte Potenz des Bohrungsradius. Die Abszissen der Grafiken 13a bis 13e stellen die normierte Plateaulänge Lₚ/Rᵢₙ dar, also den geforderten Längenabschnitt der z-Achse (Bohrungsachse), auf dem die Feldabweichung vom Nennwert B₀ weniger als 10ppm beträgt (Lₚ) geteilt durch den zuvor festgelegten Bohrungsradius (Rᵢₙ). Die Kurvenscharen stellen mit der Remanenz als Scharparameter ein Maß für die magnetische Flussdichte im Probevolumen bezogen auf die Remanenzflussdichte des verwendeten Seltenerdmaterials dar.

**Fig. 13a** zeigt zunächst die normierte Magnetlänge Lₘ/Rᵢₙ als Funktion der normierten Plateaulänge Lₚ/Rᵢₙ. Beispiel: Mit einem Seltenerdmaterial der Remanenz Br=1,4T und einer geforderten Flussdichte von B₀=1,4T erhält man die Linie "B₀/Bᵣ=1". Entsprechend der Forderung nach einer Plateaulänge von beispielsweise Lₚ=12mm und einem Bohrungsradius von Rᵢₙ=15mm erhält man eine normierte Plateaulänge von 0,8. Entsprechend lässt sich die normierte Magnetlänge in erster Näherung als 8 angeben, das heißt der Magnet müsste die achtfache Länge des Bohrungsradius aufweisen. So lassen sich bereits erste Anhaltspunkte für den Platzbedarf geben.

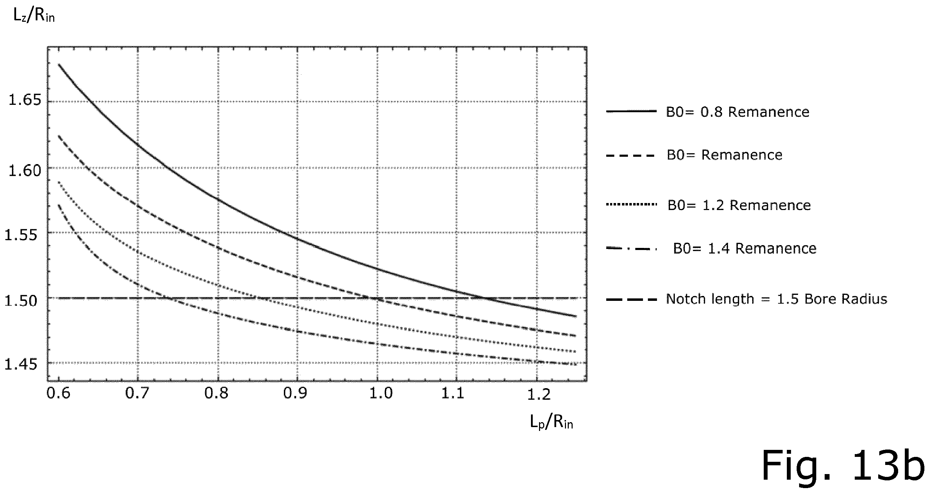

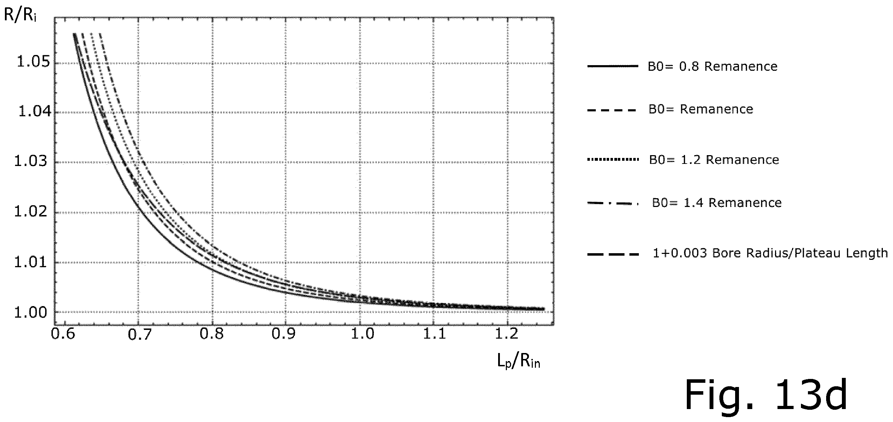

Die Grafik von **Fig. 13b** zeigt die resultierende normierte Nutlänge L_{z}/Rᵢₙ, die von **Fig. 13d** den resultierenden normierten Nutradius R/Rᵢₙ. Vorteilhaft ist demnach, wenn die Länge der nutförmigen Ausnehmung in etwa das 1,5fache des Bohrungsradius beträgt.

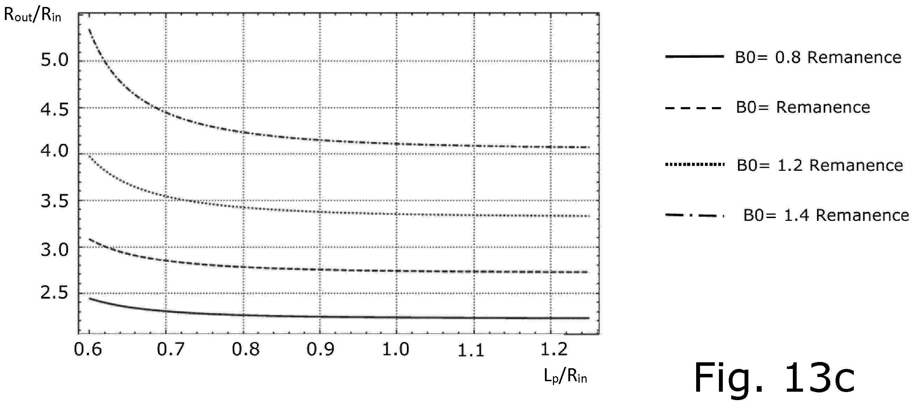

**Fig. 13c** zeigt den normierten Außenradius Rₒᵤₜ/Rᵢₙ. Hiermit kann die Baugröße abgeschätzt werden. Für das dargestellte Beispiel müsste der Außenradius etwa das 2,8fache des Innenradius betragen. Es zeigt sich außerdem, dass der Außenradius nur im Bereich kurzer Plateaulängen und damit für kurzbauende Ausführungsformen von der axialen Plateaulänge L_{P} abhängt.

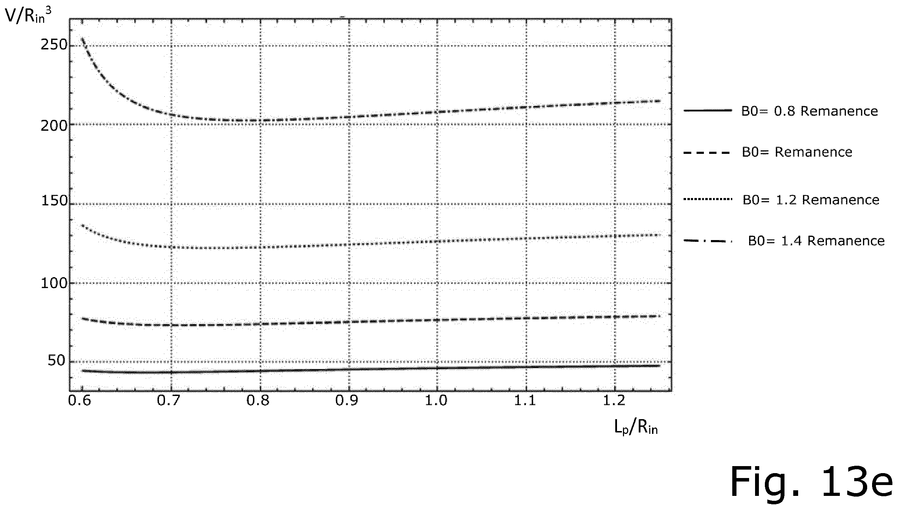

**Fig. 13e** schließlich zeigt das normierte Volumen V/Rᵢₙ³. Erkennbar ist wieder die zunehmende Abhängigkeit für kurze axiale Plateaulängen L_{P} und damit kurzbauende Ausführungsformen des erfindungsgemäßen Magnetelements.

Außerdem erkennt man, dass die nutförmige Ausnehmung mit zunehmender Länge des Magneten und damit auch der axialen Plateaulänge L_{P} immer weniger stark ausgeprägt ist. Dies liegt darin begründet, dass man sich mit zunehmender Länge wieder dem Grenzfall einer axial unendlich ausgedehnten Struktur nähert. Die Nut erfüllt aber gerade den Zweck, eine vergleichsweise kurze Magnetbaugruppe zu realisieren, die in einem eng begrenzten Abschnitt die Homogenität besitzt, die sonst nur mit einer sehr langen Baugruppe zu erreichen wäre.

### Bezugszeichenliste

- 0: Messvolumen
- 1: Magnetanordnung
- 2a-2f": ringförmige Magnetelemente
- 3a, 3b, 3d, 3': umlaufende nutförmige hohlzylindrische Ausnehmung
- 4a, 4a': zentraler Magnetring
- 4b', 4b": weitere Magnetringe

### Physikalische Größen

- x, y, z: kartesische Koordinaten
- B₀: homogenes Magnetfeld
- N: zonale Feldterme
- L_{z,M}: axiale Länge des ringförmigen Magnetelements
- Rᵢₙ: Innenradius des ringförmigen Magnetelements
- Rₒᵤₜ: maximaler Außenradius des ringförmigen Magnetelements
- L_{z,A}: axiale Länge der nutförmigen Ausnehmung
- T_{A}: radiale Tiefe der nutförmigen Ausnehmung
- L_{P}: axiale Plateaulänge des homogenen Feldbereichs im Messvolumen
- Lₚ/Rᵢₙ: normierte Plateaulänge
- L_{M}/Rᵢₙ: normierte Magnetlänge
- L_{z}/Rᵢₙ: normierte Nutlänge
- Rₒᵤₜ/Rᵢₙ: normierter Außenradius des Magnetelements
- R/Rᵢₙ: normierter Außenradius der umlaufenden Ausnehmung
- V/Rᵢₙ³: normiertes Volumen des Magnetelements

### Referenzliste:

Für die Beurteilung der Patentfähigkeit in Betracht gezogene Druckschriften
[1] US 4,931,760 A
[2] US 2010/013473 A1
[3] EP 3 217 186 B1
[4] US 2015/0061680 A1
[5] MENZEL KATHARINA ET AL: "Dipolar openable Halbach magnet design for High-Gradient Magnetic Filtration", SEPARATION AND PURIFICATION TECHNOLOGY, ELSEVIER SCIENCE, AMSTERDAM, NL, Bd. 105, 26. Dezember 2012 (2012-12-26), Seiten 114-120, XP028964621, ISSN: 1383-5866, DOI: 10.1016/J.SEPPUR.2012.12.019 Kapitel 2.1 *

## Patentansprüche

1. Magnetanordnung (1) für eine Magnetresonanz-Apparatur mit einem Permanentmagnetsystem zur Erzeugung eines homogenen Magnetfeldes B₀ in Richtung senkrecht zu einer z-Achse in einem Messvolumen (0), wobei das Permanentmagnetsystem mindestens ein konzentrisch um die z-Achse angeordnetes, hohlzylinderförmiges ringförmiges Magnetelement (2a; 2b; 2c; 2d; 2e; 2f'; 2f") aus magnetischem Material mit einer axialen Länge L_{z,M} und einem Innenradius Rᵢₙ umfasst,
wobei das ringförmige Magnetelement (2a; 2b; 2c; 2d; 2e; 2f'; 2f") aus einzelnen Magnetsegmenten aufgebaut und so angeordnet ist, dass es eine Halbach-Magnetisierung aufweist, die ein magnetisches Dipolfeld erzeugt,
**dadurch gekennzeichnet,**
**dass** das ringförmige Magnetelement (2a; 2b; 2d) eine um die z-Achse umlaufende nutförmige, hohlzylindrische Ausnehmung (3a; 3b; 3d) aufweist, die symmetrisch zur Ebene z=0 angeordnet ist und deren axiale Ausdehnung L_{z,A} geringer ist als die axiale Länge L_{z,M} des ringförmigen Magnetelements (2a; 2b; 2d), wobei die umlaufende nutförmige Ausnehmung (3a; 3b; 3d) des ringförmigen Magnetelements (2a; 2b; 2d) eine radiale Tiefe T=T_{A} sowie eine axiale Länge L_{z,A} < L_{z,M} zwischen den z-Positionen z=-z_{A} bis z=+z_{A} aufweist,
und **dass** die radiale Tiefe T_{A} sowie die axiale Länge L_{z,A} der nutförmigen Ausnehmung (3a; 3b; 3d) so gewählt sind, dass die verbleibende Inhomogenität des homogenen Magnetfeldes B₀ in einem vorgegebenen Messvolumen (0) mit einer axialen Plateaulänge L_{P} im Zentrum der Magnetanordnung (1) der Magnetresonanz-Apparatur 10ppm nicht überschreitet.

2. Magnetanordnung nach Anspruch 1, **dadurch gekennzeichnet, dass** die radiale Tiefe T_{A} sowie die axiale Länge L_{z,A} der nutförmigen Ausnehmung (3a; 3b; 3d) so gewählt sind, dass ein Halbachmagnet von mindestens 6. Ordnung entsteht, also alle zonalen Feldterme N bis N ≤ 8 im Messvolumen (0) der Magnetresonanz-Apparatur einen Wert von 10ppm nicht überschreiten, vorzugsweise ein Halbachmagnet von 8. Ordnung, also alle zonalen Feldterme bis N=10 einen Wert von 10ppm nicht überschreiten.

3. Magnetanordnung nach Anspruch 2, **dadurch gekennzeichnet, dass** die doppeltperiodischen Feldordnungen < N einen Wert von 10ppm nicht überschreiten.

4. Magnetanordnung nach einem der vorhergehenden Ansprüche, **dadurch gekennzeichnet, dass** die umlaufende nutförmige, hohlzylindrische Ausnehmung (3a; 3b) an der der z-Achse zugewandten Innenseite des ringförmigen Magnetelements (2a; 2b) angeordnet ist.

5. Magnetanordnung nach einem der vorhergehenden Ansprüche, **dadurch gekennzeichnet, dass** die umlaufende nutförmige, hohlzylindrische Ausnehmung (3') als radial innenliegende Nut durch einen separaten zentralen Magnetring (4a) mit einer axialen Ausdehnung L_{z,A} und einem Innenradius Rᵢₙ+T_{A} ausgebildet ist, der axial beiderseits jeweils von einem weiteren Magnetring (4b', 4b") mit Innenradius Rᵢₙ flankiert ist.

6. Magnetanordnung nach einem der vorhergehenden Ansprüche, **dadurch gekennzeichnet, dass** mehrere ringförmige Magnetelemente (2a; 2b; 2c; 2d; 2e) konzentrisch um die z-Achse angeordnet sind, von denen zumindest eines eine um die z-Achse umlaufende nutförmige, hohlzylindrische Ausnehmung (3a; 3b; 3d) aufweist.

7. Magnetanordnung nach einem der vorhergehenden Ansprüche, **dadurch gekennzeichnet, dass** mehrere ringförmige Magnetelemente (2a; 2f'; 2f") in z-Richtung übereinander gestapelt angeordnet sind, von denen zumindest eines eine um die z-Achse umlaufende nutförmige, hohlzylindrische Ausnehmung (3a) aufweist.

8. Magnetanordnung nach einem der Ansprüche 6 oder 7, **dadurch gekennzeichnet, dass** zumindest einige der ringförmigen Magnetelemente (2a; 2b; 2c; 2d; 2e; 2f'; 2f") aus unterschiedlichem, vorzugsweise jeweils permanent-magnetischem, Material aufgebaut sind, wobei insbesondere auch innerhalb eines einzelnen ringförmigen Magnetelements (2a; 2b; 2c; 2d; 2e; 2f'; 2f") unterschiedliche Materialien vorhanden sein können.

9. Verfahren zur Herstellung einer Magnetanordnung (1) nach einem der vorhergehenden Ansprüche, umfassend folgende Schritte:
(a) Vorgeben eines minimalen Innenradius Rᵢₙ der Magnetanordnung (1), welcher die Größe der Bohrung definiert, sowie einer kleinsten nichtverschwindenden zonalen Feldordnung N, wobei N eine positive gerade Zahl ist, sowie der gewünschten Magnetfeldstärke des homogenen Magnetfeldes B₀ im Zentrum der Magnetanordnung (1);
(b) Entwerfen eines ringförmigen Magnetelements als Grundmagnetzylinder in Halbach-Konfiguration mit vorgegebenem Magnetmaterial bekannter Remanenz, mit einem maximalen Außenradius Rₒᵤₜ und einer axialen Länge L_{z,M}, wobei das Verhältnis des Außenradius Rₒᵤₜ zur Länge des Grundmagnetzylinders Rₒᵤₜ/L_{z,M} von 10:1 bis 1:10 beträgt, vorzugsweise 3:1 bis 1:3, sodass die Zielmagnetfeldstärke B₀ im Zentrum erreicht wird;
(c) Erfassen des resultierenden Magnetfeldprofils im Bereich des Messvolumens (0) durch Bestimmung der Werte der zonalen Magnetfeldordnungen des Grundmagnetzylinders bis mindestens zur N-ten Ordnung;
(d) rechnerische Anordnung mindestens einer umlaufenden nutförmigen, hohlzylindrischen Ausnehmung im Grundmagnetzylinder symmetrisch zur Ebene z=0 mit einer niedrigeren Remanenz und Berechnen der radialen Tiefe T_{A} sowie der axialen Länge L_{z,A} < L_{z,M} zwischen den z-Positionen z=-z_{A} bis z=+z_{A} und mit L_{N} derart, dass die Summe der zonalen Magnetfeldordnungen mit Ordnung kleiner N bei dem durch die Ausnehmung modifizierten Grundmagnetzylinder verschwindet;
(e) Anpassen der vom modifizierten Grundmagnetzylinder erzeugten Magnetfeldstärke im Zentrum der Magnetanordnung (1) auf die gewünschte Magnetfeldstärke B₀ durch Verändern des Außenradius Rₒᵤₜ und/oder der axialen Länge L_{z,M} des Grundmagnetzylinders.

10. Verfahren nach Anspruch 9, **dadurch gekennzeichnet, dass** in Schritt (e) die aus Schritt (d) resultierende Feldstärke B_{0R} erfasst und der Zielmagnetfeldstärke B₀ im Zentrum der Magnetanordnung (1) angepasst wird durch Wiederholen der Schritte (b) bis (d) solange, bis B_{0R}=B₀.

11. Verfahren nach Anspruch 9 oder 10, **dadurch gekennzeichnet, dass** in einem weiteren Verfahrensschritt (f) das ringförmige Magnetelement rechnerisch aus mindestens N+2 kreisbogenförmigen Magnetsegmenten aufgebaut wird.

12. Verfahren nach einem der Ansprüche 9 bis 11, **dadurch gekennzeichnet, dass** die umlaufende nutförmige, hohlzylindrische Ausnehmung radial innen im Grundmagnetzylinder angeordnet ist, und dass der Außenradius R_{out,A} und der Innenradius R_{in,A} der Ausnehmung folgender Proportionalitätsbedingung gehorchen: (R_{in,A} + R_{out,A}) / (R_{in,A}) ∼ 1 + 0.003 * ((R_{in,A}) / (L_{P}))^{N}, wobei Lp die Plateaulänge des Messvolumens (0) im Zentrum der Magnetanordnung (1), also die axiale Ausdehnung des Messvolumens (0) bedeutet.

13. Verfahren nach einem der Ansprüche 9 bis 12, wobei die umlaufende nutförmige, hohlzylindrische Ausnehmung im Grundmagnetzylinder in einem separaten zentralen Magnetring mit einer axialen Länge L_{z,A} und einem Innenradius Rᵢₙ+T_{A} realisiert wird, sodass die Magnetanordnung (1) mindestens drei koaxial entlang der z-Achse angeordnete Einzelringe umfasst.

14. Verfahren nach den Ansprüchen 11 und 13, wobei die kreisbogenförmigen Magnetsegmente zunächst zu festen Einzelringen verklebt und in z-Richtung übereinander gestapelt werden und zur weiteren Homogenisierung des Magnetfelds der separate zentrale Magnetring in einer zur z-Richtung senkrechten x-y-Ebene verschoben wird.

15. Verfahren nach Anspruch 14, wobei die axial äußeren Magnetringe zur weiteren Homogenisierung des Magnetfelds relativ zueinander um die z-Achse verdreht und/oder verkippt werden.

## Claims

1. A magnet arrangement (1) for a magnetic resonance apparatus having a permanent magnet system for generating a homogeneous magnetic field B₀ in a direction perpendicular to a z-axis in a measurement volume (0), wherein the permanent magnet system comprises at least one hollow-cylindrical ring-shaped magnet element (2a; 2b; 2c; 2d; 2e; 2f'; 2f") composed of magnetic material having an axial length L_{z,M} and an inner radius Rᵢₙ, said magnet element being arranged concentrically around the z-axis,
wherein the ring-shaped magnet element (2a; 2b; 2c; 2d; 2e; 2f'; 2f") is constructed from individual magnet segments and is arranged such that it has a Halbach magnetization that generates a magnetic dipole field, **characterized in that**
the ring-shaped magnet element (2a; 2b; 2d) has a notched, hollow-cylindrical cutout (3a; 3b; 3d) extending circumferentially around the z-axis, said cutout being arranged symmetrically with respect to the plane z = 0 and the axial extent L_{z,A} of said cutout being less than the axial length L_{z,M} of the ring-shaped magnet element (2a; 2b; 2d), wherein the circumferential notched cutout (3a; 3b; 3d) of the ring-shaped magnet element (2a; 2b; 2d) has a radial depth T = T_{A} and an axial length L_{z,A} < L_{z,M} between the z-positions z = -z_{A} to z = + z_{A},
and the radial depth T_{A} and the axial length L_{z,A} of the notched cutout (3a; 3b; 3d) are chosen such that the remaining inhomogeneity of the homogenous magnetic field B₀ in a predefined measurement volume (0) having an axial plateau length L_{P} in the center of the magnet arrangement (1) of the magnetic resonance apparatus does not exceed 10 ppm.

2. The magnet arrangement as claimed in claim 1, **characterized in that** the radial depth T_{A} and the axial length L_{z,A} of the notched cutout (3a; 3b; 3d) are chosen such that an at least 6th-order Halbach magnet arises, that is to say that all zonal field terms N to N ≤ 8 in the measurement volume (0) of the magnetic resonance apparatus do not exceed a value of 10 ppm, preferably an 8th-order Halbach magnet, that is to say that all zonal field terms up to N = 10 do not exceed a value of 10 ppm.

3. The magnet arrangement as claimed in claim 2, **characterized in that** the doubly periodic field orders < N do not exceed a value of 10 ppm.

4. The magnet arrangement as claimed in any of the preceding claims, **characterized in that** the circumferential notched, hollow-cylindrical cutout (3a; 3b) is arranged at the inner side of the ring-shaped magnet element (2a; 2b) facing the z-axis.

5. The magnet arrangement as claimed in any of the preceding claims, **characterized in that** the circumferential notched, hollow-cylindrical cutout (3') is embodied as a radially inner notch through a separate central magnet ring (4a) having an axial extent L_{z,A} and an inner radius Rᵢₙ + T_{A}, which is flanked axially on both sides in each case by a further magnet ring (4b', 4b") having an inner radius Rᵢₙ.

6. The magnet arrangement as claimed in any of the preceding claims, **characterized in that** a plurality of ring-shaped magnet elements (2a; 2b; 2c; 2d; 2e) are arranged concentrically around the z-axis, at least one of which has a notched, hollow-cylindrical cutout (3a; 3b; 3d) extending circumferentially around the z-axis.

7. The magnet arrangement as claimed in any of the preceding claims, **characterized in that** a plurality of ring-shaped magnet elements (2a; 2f'; 2f") are arranged in a manner stacked one above another in the z-direction, at least one of which has a notched, hollow-cylindrical cutout (3a) extending circumferentially around the z-axis.

8. The magnet arrangement as claimed in either of claims 6 and 7, **characterized in that** at least some of the ring-shaped magnet elements (2a; 2b; 2c; 2d; 2e; 2f'; 2f") are constructed from different, preferably in each case permanent-magnetic, material, wherein different materials can be present in particular also within an individual ring-shaped magnet element (2a; 2b; 2c; 2d; 2e; 2f'; 2f").

9. A method for producing a magnet arrangement (1) as claimed in any of the preceding claims, comprising the following steps:
(a) predefining a minimum inner radius Rᵢₙ of the magnet arrangement (1), said radius defining the size of the bore, and a smallest non-vanishing zonal field order N, wherein N is a positive even number, and the desired magnetic field strength of the homogenous magnetic field B₀ in the center of the magnet arrangement (1);
(b) designing a ring-shaped magnet element as a basic magnet cylinder in a Halbach configuration comprising predefined magnet material of known remanence, having a maximum outer radius Rₒᵤₜ and an axial length L_{z,M}, wherein the ratio of the outer radius Rₒᵤₜ to the length of the basic magnet cylinder Rₒᵤₜ/L_{z,M} is from 10:1 to 1:10, preferably 3:1 to 1:3, such that the target magnetic field strength B₀ is attained in the center;
(c) detecting the resulting magnetic field profile in the region of the measurement volume (0) by determining the values of the zonal magnetic field orders of the basic magnet cylinder up to at least the N-th order;
(d) computationally arranging at least one circumferential notched, hollow-cylindrical cutout in the basic magnet cylinder symmetrically with respect to the plane z = 0 with a lower remanence and calculating the radial depth T_{A} and the axial length L_{z,A} < L_{z,M} between the z-positions z = -z_{A} to z = + z_{A} and with L_{N} in such a way that the sum of the zonal magnetic field orders with order less than N vanishes in the case of the basic magnet cylinder modified by the cutout;
(e) adapting the magnetic field strength generated by the modified basic magnet cylinder in the center of the magnet arrangement (1) to the desired magnetic field strength B₀ by altering the outer radius Rₒᵤₜ and/or the axial length L_{z,M} of the basic magnet cylinder.

10. The method as claimed in claim 9, **characterized in that** in step (e) the field strength B_{0R} resulting from step (d) is detected and the target magnetic field strength B₀ in the center of the magnet arrangement (1) is adapted by repeating steps (b) to (d) until B_{0R} = B₀.

11. The method as claimed in claim 9 or 10, **characterized in that** in a further method step (f) the ring-shaped magnet element is constructed computationally from at least N + 2 circle-arc-shaped magnet segments.

12. The method as claimed in any of claims 9 to 11, **characterized in that** the circumferential notched, hollow-cylindrical cutout is arranged radially on the inside in the basic magnet cylinder, and that the outer radius R_{out,A} and the inner radius R_{in,A} of the cutout satisfy the following proportionality condition: (R_{in,A} + R_{out,A})/(R_{in,A}) ∼ 1 + 0.003 * ((R_{in,A})/(L_{P}))^{N}, wherein L_{P} denotes the plateau length of the measurement volume (0) in the center of the magnet arrangement (1), that is to say the axial extent of the measurement volume (0).

13. The method as claimed in any of claims 9 to 12, wherein the circumferential notched, hollow-cylindrical cutout is realized in the basic magnet cylinder in a separate central magnet ring having an axial length L_{z,A} and an inner radius Rᵢₙ + T_{A}, such that the magnet arrangement (1) comprises at least three individual rings arranged coaxially along the z-axis.

14. The method as claimed in claims 11 and 13, wherein the circle-arc-shaped magnet segments firstly are adhesively bonded to form fixed individual rings and are stacked one above another in the z-direction and, for further homogenization of the magnetic field, the separate central magnet ring is displaced in an x-y-plane perpendicular to the z-direction.

15. The method as claimed in claim 14, wherein, for further homogenization of the magnetic field, the axially outer magnet rings are rotated and/or tilted relative to one another about the z-axis.

## Revendications

1. Dispositif magnétique (1) pour un appareil de résonnance magnétique avec un système d'aimant permanent pour produire un champ magnétique homogène B₀ s'étendant dans une direction perpendiculaire à un axe z dans un volume mesuré (0), le système d'aimant permanent comprenant au moins un élément magnétique (2a ; 2b ; 2c ; 2d ; 2e ; 2f' ; 2f") disposé de façon concentrique autour de l'axe z, en forme de cylindre creux et de bague, composé de matière magnétique avec une longueur axiale L_{z,M} et un rayon intérieur Rᵢₙ, l'élément magnétique (2a ; 2b ; 2c ; 2d ; 2e ; 2f' ; 2f") en forme de bague étant composé de segments magnétiques individuels et étant disposé de telle sorte qu'il comporte une magnétisation de Halbach qui produit un champ de dipôle magnétique ; **caractérisé en ce que** :
l'élément magnétique (2a ; 2b ; 2d) cylindrique creux en forme de bague comporte une encoche (3a ; 3b ; 3d) en forme de rainure passant autour de l'axe z qui est disposée symétriquement par rapport au plan z = 0 et dont l'extension axiale L_{z,A} est plus réduite que la longueur axiale L_{z,M} de l'élément magnétique (2a ; 2b ; 2d) en forme de bague, l'encoche (3a ; 3b ; 3d) périphérique en forme de rainure de l'élément magnétique (2a ; 2b ; 2d) en forme de bague présentant une profondeur radiale T = T_{A} ainsi qu'une longueur axiale L_{z,A} < L_{z,M} entre les positions z z = -z_{A} à z = +z_{A} ; et
la profondeur radiale T_{A} ainsi que la longueur axiale L_{z,A} de l'encoche (3a ; 3b ; 3d) en forme de rainure sont choisis de telle sorte que la non-homogénéité du champ magnétique homogène B₀ ne dépasse pas 10 ppm dans un volume mesuré (0) prédéfini avec une longueur de plateau axiale Lp au centre du dispositif magnétique (1) de l'appareil de résonnance magnétique.

2. Dispositif magnétique selon la revendication 1, **caractérisé en ce que** la profondeur radiale T_{A} ainsi que la longueur axiale L_{z,A} de l'encoche (3a ; 3b ; 3d) en forme de rainure sont choisies de telle sorte qu'un aimant de Halbach d'ordre au moins 6 se produise, donc de sorte que toutes les expressions algébriques de champ zonal N à N ≤ 8 dans le volume mesuré (0) de l'appareil de résonnance magnétique ne dépassent pas une valeur de 10 ppm, de préférence un aimant de Halbach d'ordre 8, donc dans lequel toutes les expressions algébriques de champ zonal jusqu'à N = 10 ne dépassent pas une valeur de 10 ppm.

3. Dispositif magnétique selon la revendication 2, **caractérisé en ce que** les ordres de champ à double période < N ne dépassent une valeur de 10 ppm.

4. Dispositif magnétique selon l'une quelconque des revendications précédentes, **caractérisé en ce que** l'encoche (3a ; 3b) cylindrique creuse périphérique en forme de rainure est disposée au niveau du côté intérieur, orienté vers l'axe z, de l'élément magnétique (2a ; 2b) en forme de bague.

5. Dispositif magnétique selon l'une quelconque des revendications précédentes, **caractérisé en ce que** l'encoche (3') cylindrique creuse périphérique en forme de rainure est réalisée sous la forme d'une rainure reposant à l'intérieur dans le plan radial à travers une bague magnétique (4a) centrale séparée avec une extension axiale L_{z,A} et un rayon intérieur Rᵢₙ + T_{A} respectivement flanqués des deux côtés dans le plan axial d'une bague magnétique (4b', 4b") supplémentaire avec un rayon intérieur Rᵢₙ.

6. Dispositif magnétique selon l'une quelconque des revendications précédentes, **caractérisé en ce que** plusieurs éléments magnétiques (2a ; 2b ; 2c ; 2d ; 2e) en forme de bague sont disposés de façon concentrique autour de l'axe z, parmi lesquels au moins un comporte une encoche (3a ; 3b ; 3d) cylindrique creuse périphérique passant autour de l'axe z.

7. Dispositif magnétique selon l'une quelconque des revendications précédentes, **caractérisé en ce que** plusieurs éléments magnétiques (2a ; 2f ; 2f") en forme de bague sont disposés de façon empilée les uns au-dessus des autres dans la direction z parmi lesquels au moins un comporte une encoche (3a) cylindrique creuse en forme de rainure périphérique passant autour de l'axe z.

8. Dispositif magnétique selon l'une quelconque des revendications 6 ou 7, **caractérisé en ce qu'**au moins quelques-uns des éléments magnétiques (2a ; 2b ; 2c ; 2d ; 2e ; 2f ; 2f") en forme de bague sont composés de différents matériaux, de préférence respectivement à aimant permanent, différents matériaux pouvant notamment être également présents à l'intérieur d'un élément magnétique (2a ; 2b ; 2c ; 2d ; 2e ; 2f' ; 2f") en forme de bague individuel.

9. Procédé de fabrication d'un dispositif magnétique (1) selon l'une quelconque des revendications précédentes, comprenant les étapes suivantes :
(a) prédéfinition d'un rayon intérieur Rᵢₙ minimal du dispositif magnétique (1) qui définit la taille de l'alésage, ainsi que d'un ordre de champ zonal N plus petit ne disparaissant pas, N étant un nombre entier positif, ainsi que la puissance de champ magnétique souhaitée du champ magnétique homogène B₀ au centre du dispositif magnétique (1) ;
(b) conception d'un élément magnétique en forme de bague réalisé sous la forme d'un cylindre magnétique de base dans la configuration de Halbach avec une matière magnétique prédéfinie de rémanence connue, avec un rayon extérieur Rₒᵤₜ maximal et une longueur axiale L_{z,M}, le rapport du rayon extérieur Rₒᵤₜ sur la longueur du cylindre magnétique de base Rₒᵤₜ /L_{z,M} étant de 10:1 à 1:10, de préférence de 3:1 à 1:3, de sorte que la puissance de champ magnétique cible B₀ soit atteinte au centre ;
(c) détermination du profil de champ magnétique résultant dans la région du volume mesuré (0) par détermination des valeurs des ordres de champ magnétique zonal du cylindre magnétique de base jusqu'à au moins l'ordre N ;
(d) agencement par le calcul d'au moins une encoche cylindrique creuse périphérique en forme de rainure dans le cylindre magnétique de base symétriquement par rapport au plan z = 0 avec une rémanence plus faible et calcul de la profondeur radiale T_{A} ainsi que de la longueur axiale L_{z,A} < L_{z,M} entre les positions z z = -z_{A} à Z = +z_{A} et avec L_{N} de telle sorte que la somme des ordres de champ magnétique zonal disparaisse avec l'ordre plus petit N avec lequel le cylindre magnétique de base modifié par l'encoche disparaît ;
(e) adaptation de la puissance de champ magnétique produite par le cylindre magnétique de base modifié au centre du dispositif magnétique (1) à la puissance de champ magnétique B₀ souhaitée par modification du rayon extérieur Rₒᵤₜ et/ou de la longueur axiale L_{z,M} du cylindre magnétique de base.

10. Procédé selon la revendication 9, **caractérisé en ce qu'**au cours de l'étape (e), l'intensité de champ B_{0R} résultant de l'étape (d) est déterminée et que la puissance de champ magnétique cible B₀ au centre du dispositif magnétique (1) est adaptée par répétition des étapes (b) à (d) jusqu'à ce que B_{0R} = B₀.

11. Procédé selon la revendication 9 ou 10, **caractérisé en ce qu'**au cours d'une étape de procédé supplémentaire (f), l'élément magnétique en forme de bague est structuré par calcul à partir d'au moins N+2 segments magnétiques en forme d'arc de cercle.

12. Procédé selon l'une quelconque des revendications 9 à 11, **caractérisé en ce que** l'encoche cylindrique creuse périphérique en forme de rainure est disposée à l'intérieur dans le plan radial du cylindre magnétique de base et que le rayon extérieur R_{out,A} et le rayon intérieur R_{in,A} de l'encoche obéissent aux conditions de proportionnalité suivantes : (R_{in,A} + R_{out,A}) / (R_{in,A}) ∼ 1 + 0.003 * ((R_{in,A}) / (L_{P}))^{N}, L_{P} étant la longueur de plateau du volume mesuré (0) au centre du dispositif magnétique (1), donc l'extension axiale du volume mesuré (0).

13. Procédé selon l'une quelconque des revendications 9 à 12, l'encoche cylindrique creuse en forme de rainure étant réalisée dans le cylindre magnétique de base dans une bague magnétique centrale séparée avec une longueur axiale L_{z,A} et un rayon intérieur Rᵢₙ + T_{A}, de sorte que le dispositif magnétique (1) comprenne au moins trois bagues individuelles disposées dans le plan coaxial le long de l'axe z.

14. Procédé selon les revendications 11 et 13, les segments magnétiques en forme d'arc de cercle étant d'abord collés pour former des bagues individuelles fixes et empilés les uns sur les autres dans la direction z et décalés pour une homogénéisation supplémentaire du champ magnétique de la bague magnétique centrale séparée dans un plan x-y perpendiculaire au plan z.

15. Procédé selon la revendication 14, les bagues magnétiques extérieures dans le plan axial étant tordues et/ou basculées les unes par rapport aux autres autour de l'axe z pour une homogénéisation supplémentaire du champ magnétique.
